(19) Europäisches Patentamt
European Patent Office
Office européen des brevets

(11) EP 1 594 006 A2

(12) **EUROPEAN PATENT APPLICATION**

(43) Date of publication:
**09.11.2005 Bulletin 2005/45**

(51) Int Cl.⁷: **G03F 7/20**, G03F 7/24

(21) Application number: **05006730.5**

(22) Date of filing: **29.03.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **29.03.2004 JP 2004096109**

(71) Applicant: **FUJI PHOTO FILM CO., LTD.**
**Kanagawa 250-01 (JP)**

(72) Inventors:
- **Matsuoka, Hiroshi**
**Ashigara-kami-gun Kanagawa (JP)**
- **Sunagawa, Hiroshi**
**Ashigara-kami-gun Kanagawa (JP)**
- **Katoh, Yoshinori**
**Ashigara-kami-gun Kanagawa (JP)**
- **Kiso, Takeshi**
**Ashigara-kami-gun Kanagawa (JP)**
- **Kimura, Akinori**
**Ashigara-kami-gun Kanagawa (JP)**
- **Miyagawa, Ichirou**
**Ashigara-kami-gun Kanagawa (JP)**

(74) Representative: **Klunker . Schmitt-Nilson . Hirsch**
**Winzererstrasse 106**
**80797 München (DE)**

(54) **Method for making a printing plate and a plate exposing apparatus**

(57) The method and apparatus make a printing plate such as a lithographic printing plate by exposing an original plate of the printing plate such as a presensitized plate in a substantially oxygen-free state. The method and apparatus deprive substantially of oxygen at least an exposed area of the original plate being exposed to light at least during exposure and expose the original plate to the light at a wavelength of between 250 nm and 420 nm. The original plate has on a support an image recording layer containing a polymerization initiator, a polymerizable compound and a binder polymer, being sensitive to the light at the wavelengths of between 250 nm and 420 nm, having no oxygen barrier layer, and being removable with a printing ink and/or a fountain solution. That is, a latent image is formed by photo-polymerization on the original plate and the original plate is subjected to development on a printing press.

EP 1 594 006 A2

## Description

BACKGROUND OF THE INVENTION

This invention relates to a method for making a printing plate and a plate exposing apparatus for use in the method. More specifically, the invention relates to a method for making a printing plate such as a lithographic printing plate by means of a direct plate making process, that is, by effecting direct image recording on an original plate or a virgin plate of the printing plate such as the lithographic printing plate, that is, a so-called presensitized plate using a light source that emits at the wavelengths of between 250 nm and 420 nm, the original plate of the lithographic printing plate or the presensitized plate allowing for printing to be done by on-press development in place of the conventional development processing. The invention also relates to a plate exposing apparatus for use in the method.

Lithographic printing plates generally have a surface that comprises oleophilic image areas and hydrophilic nonimage areas. In lithography, a fountain solution and an oily ink are applied alternately to the plate surface and since water and oil repel each other, the hydrophilic non-image areas accept the fountain solution (and not the ink) whereas the oleophilic image areas accept the ink, which is transferred onto a printing medium such as paper (on which print is done).

To make such lithographic printing plates, presensitized plates (PS plates) which carry an oleophilic light-sensitive resin layer (image recording layer) on a hydrophilic support conventionally find extensive use. Typically, the PS plate is exposed to light through an original such as a litho film and, thereafter, only those portions of the image recording layer which serve as the image areas are left intact whereas the other unwanted portions of the image recording layer are dissolved away with an alkaline developer solution or an organic solvent, thereby revealing the hydrophilic support surface to form the nonimage areas.

In the conventional process of making lithographic printing plates from the PS plate, exposure must be followed by the step of dissolving away the unwanted portions of the image recording layer with a developer solution and the like but the printing industry sees it necessary to eliminate or simplify this additional wet processing. In particular, with the recent concern over the Earth's environment, the disposal of liquid wastes from the wet processing has become a major consideration for the industry at large, further increasing the urgency of solving the aforementioned problem.

To this end, a convenient lithographic platemaking process has been proposed. Called "on-press development", this method starts with a PS plate that uses a special type of image recording layer that can be removed in the usual printing process and, after exposure, the method removes the unwanted portions of the image recording layer on the printing press to make a desired lithographic printing plate.

Specific ways to implement the "on-press development" include: a method of using a PS plate having an image recording layer that can be dissolved or dispersed in a fountain solution, an ink solvent or an emulsion of the fountain solution and the ink; a method of mechanically removing the image recording layer by contact with rollers or a blanket on the press; and a method in which the cohesive force of the image recording layer or the adhesion between the image recording layer and the support is weakened by permeation of the fountain solution, ink solvent, etc. and, thereafter, the image recording layer is mechanically removed by contact with rollers or a blanket on the press.

In the present invention, unless otherwise noted, the term "conventional development processing" refers to the process of bringing the image recording layer in a PS plate on an apparatus other than a printing press (which is typically an automatic processor) into contact with a liquid (which is typically an alkaline developer solution), so that the unwanted portions of the image recording layer are removed, thus revealing the hydrophilic support surface, and the term "on-press development" refers to the method and process of bringing the image recording layer in a PS plate on a printing press into contact with a liquid (which is typically a printing ink and/or a fountain solution), so that the unwanted portions of the image recording layer are removed, thus revealing the hydrophilic support surface.

Also spreading widely today in the field of image creation is digital technology which involves computer-aided electronic processing, accumulation and outputting of image information and this has led to commercialization of various new image outputting systems that meet the needs of such digital technology. Along with this development, the computer-to-plate technology is attracting researchers' attention; in this technology, digital image information is carried on a highly convergent radiation such as laser light, which is used to scan and expose a PS plate, thereby achieving direct making of a lithographic printing plate without requiring a litho film. Therefore, obtaining a PS plate that is adaptive to this technology is another important technical problem to be addressed by the printing industry.

Thus, simplifying the platemaking job, making a shift from the wet to the dry process and eliminating the conventional development processing have recently become more pressing requirements than ever before from the viewpoints of both the concern over the Earth's environment and the need for adaptation to digital technology.

A solution to this problem can be found in JP 47-8657 A which teaches that a light-sensitive composition containing poly(vinylpyrrolidone), a polymeric polycarboxylic acid, an olefinically unsaturated monomer, a photoinitiator, etc. is used to make a lithographic printing plate which, after exposure, can be immediately mounted on a press for printing purposes. However, the photoinitiator used in that patent has had problems with sensitivity and fog after exposure.

In the case of exposing a radical polymerizable presensitized plate, the optical power required to form image varies greatly with the rate of oxygen inflow into the image recording layer. This may be expressed mechanistically as follows.

If the amount of radicals generated is written as N, it is generally proportional to the applied exposing energy J:

$$J = c1 \cdot N \text{ (c1 is a proportionality constant).}$$

The radicals generated by the applied light are entrapped by the oxygen flowing into the image recording layer. The amount of entrapped radicals $N_o$ is proportional to q, the amount of oxygen inflow per unit time, and t, or the time lapsed from the start of exposure:

$$No = c2 \cdot q \cdot t \text{ (c2 is another proportionality constant).}$$

From those equations, $J_o$, or the exposing energy that will not participate in polymerization even if radicals are generated, can be expressed as follows:

$$J_o = c1 \cdot c2 \cdot q \cdot t.$$

Therefore, the exposing energy J that is required for image formation must be higher than $J_o$.

On the other hand, if more radicals are generated by short exposure than the inflow of oxygen, polymerization is prone to be complete within a short time, so it follows that the threshold energy to be applied $J_{th}$ is determined independent of the oxygen inflow.

This relationship may be represented in Fig. 8 by a graph in which the horizontal axis plots the time of irradiation and the vertical axis, the applied energy J. Obviously, in the case of conventional planar exposure that takes time on the order of minutes, more radicals are entrapped by the oxygen flowing into the image recording layer, so very high energy must be applied. In contrast, if irradiation can be effected within the time period for $J_{th}$, image formation is possible by the application of only low energy.

Studies by the present inventors have shown that with the radical polymerizable photosensitized plate which is processed by the platemaking method according to the first aspect of the present invention, the above-defined time period for irradiation needs to be no longer than 1 millisecond (msec).

However, in order to form image on the presensitized plate with one pixel being irradiated for no longer than 1 millisecond (msec), an intense, spatially coherent light source (laser) has been necessary. Yet, a light source that could produce high output power at wavelengths of between 250 nm and 420 nm was expensive, leading to an increase in equipment cost.

Even if the wavelength range is adjusted to lie between 250 nm and 420 nm, the overlap with the emission spectrum of the indoor illumination is not completely absent; therefore, if the presensitized plate is placed under prolonged exposure to the indoor illumination or if, for the purpose of testing for scum on the plate or other defects, it is placed in a testing environment under illumination with a fluorescent lamp at near distance, it has been difficult to assure complete prevention of unwanted image formation.

As a way to enable recording with a light source of low illuminance, it is commonly practiced to provide an oxygen barrier layer on top of a light-sensitive layer, thereby blocking the ingress of oxygen. However, this is not compatible with the requirement for preventing the formation of unwanted image; the light-sensitive material having the oxygen barrier layer has such high sensitivity that unwanted image forms extensively under indoor illumination.

There has been another problem with the use of the oxygen barrier layer; PVA (polyvinyl alcohol) which is widely used to make this layer is a water-soluble compound, so it dissolves in the fountain solution on the printing press and contaminates its interior, giving rise to printed matter with scum.

SUMMARY OF THE INVENTION

The present invention has been accomplished under these circumstances and has as an object providing a method for making a printing plate such as a lithographic printing plate from a original plate or virgin plate of the printing plate such as the lithographic printing plate, that is, a presensitized plate in which the overall process can be performed in a lighted room, image recording can be effected with a light source (e.g. a mercury lamp) emitting at wavelengths of between 250 nm and 420 nm, printing simply requires on-press development in place of the conventional (alkali)

development processing, and the original plate or the presensitized plate has outstanding on-press developability, press life and safety under white light.

Another object of the present invention is to provide a plate exposing apparatus that can suitably be used to implement the method.

The first object of the present invention can be attained by a method for making a printing plate (lithographic printing plate), comprising: substantially depriving of oxygen at least an exposed area of an original plate of a lithographic printing plate (presensitized plate) being exposed to light at least during exposure; and exposing the original plate to the light at a wavelength of between 250 nm and 420 nm, wherein the original plate of the lithographic printing plate has on a support an image recording layer containing a polymerization initiator, a polymerizable compound and a binder polymer, being sensitive to the light at the wavelengths of between 250 nm and 420 nm, having no oxygen barrier layer, and being removable with a printing ink and/or a fountain solution.

In the method of the present invention for making the printing plate such as the lithographic printing plate, the exposed areas and their neighborhood are preferably held substantially oxygen-free state after the exposure for a specified period of time until the progress of polymerization reaction is complete and adequate press life is obtained. In the method of the present invention for making the printing plate such as the lithographic printing plate, it is more preferred that the exposed areas and their neighborhood are held substantially oxygen-free state for a specified period of time both before and after the exposure. The period of time for which the substantially oxygen-free state is maintained should be determined by the combination of the polymerization initiator, polymerizable compound and binder polymer and in general it preferably ranges from several to several tens of seconds.

The concentration of oxygen in the substantially oxygen-free state should also be determined by the combination of the polymerization initiator, polymerizable compound and binder polymer and in general the oxygen concentration is preferably 0.5% or less, more preferably 0.05% or less.

In the method of the present invention for making the printing plate such as the lithographic printing plate, after the exposed areas and their neighborhood are held substantially oxygen-free state for a specified period of time following the exposure, the original plate (presensitized plate) exposed to the light is exposed to atmospheric air to inhibit occurrence of photopolymerization.

In the method of the present invention for making the printing plate such as the lithographic printing plate, the substantially oxygen-free state is preferably maintained by replacement with an inert gas of air in a closed space formed by a transparent retainer member that retains the original plate (presensitized plate) on a first side where the image recording layer is provided and a press member that covers a second side of the support of the original plate and which can be moved to contact or depart from the transparent retainer member. Alternatively, the substantially oxygen-free state is preferably maintained by displacing air in a closed space formed by a transparent retainer member that retains the original plate (presensitized plate) on a first side where the image recording layer is provided and a press member that covers a second side of the support of the original plate and which can be moved to contact or depart from the transparent retainer member.

The second object of the present invention can be attained by a plate exposing apparatus, comprising: exposure means for exposing to light an original plate (presensitized plate) of a printing plate (lithographic printing plate) that does not have an oxygen barrier layer, on which latent image is formed by photo-polymerization and which is subjected to development on a printing press; and oxygen blocking means for ensuring that exposure is performed such that at least an exposed area of the original plate being exposed to the light are substantially deprived of oxygen at least during the exposure.

In a preferred embodiment of the present invention, the plate exposing apparatus further comprises: oxygen blocking time control means for controlling a period of time for which oxygen is interrupted by the oxygen blocking means, that is, the apparatus may, in addition to the oxygen blocking means, have the oxygen blocking time control means.

The oxygen blocking time control means is preferably capable of controlling oxygen interruption for any duration of time in the period between a first specified time before and a second specified time after the exposure of the original plate (presensitized plate).

The oxygen blocking means preferably comprises: a transparent retainer member that retains the original plate on a first side where the image recording layer is provided; a press member that covers a second side of the support of the original plate (presensitized plate) and which can be moved to contact or depart from the transparent retainer member; and replacement means for replacing with an inert gas air in a closed space formed by the transparent retainer member and the press member. Alternatively, the oxygen blocking means may preferably comprise: a transparent retainer member that retains the original plate (presensitized plate) on a first side where the image recording layer is provided; a press member that covers a second side of the support of the original plate and which can be moved to contact or depart from the transparent retainer member; and displacement means for displacing air in a closed space formed by the transparent retainer member and the press member.

In a preferred embodiment of the invention, the plate exposing apparatus is a flat bed type exposing apparatus

for scanning on a plane of a flat bed, an inner drum type exposing apparatus for scanning on an inner surface of a drum or an outer drum type exposing apparatus for scanning on an outer surface of a drum. In the plate exposing apparatus of the invention, the transparent retainer member that retains the original plate (presensitized plate) on the first side where the image recording layer is provided and a press member that covers the second side of the support of the original plate and which can be moved to contact or depart from the transparent retainer member are combined and assembled for scanning on either a plane of a flat bed or an inner surface of a drum (cylinder) or an outer surface of a drum (cylinder).

These and other features of the present invention will become apparent from the following description.

According to the present invention, there is obtained the printing plate such as the lithographic printing plate having the following features: image can be recorded with the comparatively inexpensive light source (e.g. low-power laser and mercury lamp) although it emit at between 250 nm and 420 nm, and this contributes to reducing the equipment cost; printing can be done by on-press development in place of the conventional (alkali) development processing; the plate has outstanding on-press developability and press life; the plate has safety under white light, so even if it is left in a lighted environment for an extended period of time after exposure, printing can be done without forming any unwanted image. Hence, the practical benefits to people in the industry are considerable from various viewpoints including operational safety, efficiency and the quality of final printed matter.

The present invention also provides the plate exposing apparatus that can suitably be employed to implement the method for making the printing plate such as the lithographic printing plate that has the various advantages mentioned above.

The resulting benefit to the operator is that the above-described safe and efficient process of making the printing plate such as the lithographic printing plate can be implemented in a positive and easy way.

BRIEF DESCRIPTION OF THE DRAWINGS

Figs. 1A and 1B are side views showing schematically a plate exposing apparatus according to an embodiment of the second aspect of the present invention;

Fig. 2 is a flow sheet showing the sequence of major steps in the method of making the lithographic printing plate according to an embodiment of the first aspect of the present invention;

Fig. 3 is a side view showing schematically a plate exposing apparatus according to another embodiment of the second aspect of the present invention;

Figs. 4A and 4B are side views showing schematically a plate exposing apparatus according to still another embodiment of the second aspect of the present invention;

Fig. 5 is a side view showing schematically a plate exposing apparatus according to yet another embodiment of the second aspect of the present invention;

Figs. 6A, 6B, 6C and 6D are side views showing schematically a plate exposing apparatus according to a further embodiment of the second aspect of the present invention;

Fig. 7A is a perspective view showing schematically a plate exposing apparatus according to a still further embodiment of the second aspect of the present invention;

Fig. 7B is a longitudinal section of the same apparatus; and

Fig. 8 is a graph showing how the time for which a radical polymerizable presensitized plate is exposed to a radiation is related to the resulting energy of irradiation J.

BEST MODES FOR CARRYING OUT THE INVENTION

The following description begins with an original or virgin plate of a printing plate such as a lithographic printing plate, that is, a presensitized plate suitable for exposure by the plate exposing apparatus according to the second aspect of the present invention; then, on the basis of the preferred embodiments shown in accompanying drawings, exemplary configurations of the plate exposing apparatus will be described; only thereafter is described the method of making a printing plate such as a lithographic printing plate using the same apparatus.

<On-press development processing>

Specific methods for printing without passing through the conventional development processing include, but are not limited to, a process comprising exposing a presensitized plate, mounting it on a printing press without performing the conventional development processing, and applying a printing step, and a process comprising mounting a presensitized plate on a printing press, exposing it on the press, and applying a printing step to the exposed plate.

After imagewise exposure, the exposed areas of the image recording layer in the presensitized plate polymerize to harden and become insoluble. Without applying the conventional development processing such as wet development processing, the exposed presensitized plate is supplied with an oily ink and an aqueous component for printing; in the unexposed areas, the oily ink and/or aqueous component cause the unhardened portions of the image recording layer to be dissolved or dispersed away, revealing the hydrophilic support surface in those areas. In the exposed areas, the hardened portions of the image recording layer remain intact, forming oily ink receptive areas (image areas) having an oleophilic surface.

As a result, the aqueous component adheres to the revealing hydrophilic surface whereas the oily ink deposits on the image recording layer in the exposed areas to start printing. What is first supplied to the plate surface may be the aqueous component or the oily ink; however, in order to prevent contamination of the aqueous component by the image recording layer in the unexposed areas, the oily ink is preferably supplied first. As the aqueous component and oily ink, the fountain solution and printing ink for the conventional lithographic printing process are respectively employed.

In the manner described above, the presensitized plate is subjected to on-press development on an offset printing machine and used as such for producing a large number of prints.

[Presensitized plate]

The presensitized plate as the original plate of the printing plate to be used in the present invention has a support overlaid with an image recording layer that contains (A) a polymerization initiator, (B) a polymerizable compound and (C) a binder polymer and which is sensitive to light at wavelengths of between 250 nm and 420 nm.

On the following pages, the constituent elements of the presensitized plate are described.

<(A) Polymerization initiator>

The polymerization initiator to be used in the present invention is a compound that generates radicals by light energy to initiate and promote the polymerization of compounds having polymerizable unsaturated groups. In particular, the polymerization initiator is a compound which, either alone or in combination with a sensitizer to be described later, absorbs light at 250 nm - 420 nm to generate radicals. Such a photo-radical generator can appropriately be chosen from known polymerization initiators, compounds having bonds with small bond dissociation energy, etc.

In this connection, the emission spectrum intensity of white light is high in the visible range exceeding 400 nm and polymerization initiators having adequate light sensitivity in that range are prone to cause fog under white light; hence, the absorption maxima of initiators and sensitizers are preferably adjusted to be no greater than 400 nm.

The above-described compounds that generate radicals include, but are not limited to, organohalogen compounds, carbonyl compounds, organic peroxides, azo-based compounds, azide compounds, metallocene compounds, hexaarylbiimidazole compounds, organoboron compounds, disulfone compounds, oxime ester compounds, and onium salt compounds.

Specific examples of the organohalogen compound include the compounds described in Wakabayashi et al., Bull. Chem. Soc. Japan, 42, 2924 (1969), US 3,905,815 B, JP 46-4605 B, JP 48-36281 A, JP 53-133428 A, JP 55-32070 A, JP 60-239736 A, JP 61-169835 A, JP 61-169837 A, JP 62-58241 A, JP 62-212401 A, JP 63-70243 A, JP 63-298339 A, and M.P. Hutt, Journal of Heterocyclic Chemistry, 1 (No. 3), 1970. Among these compounds, trihalomethyl-substituted oxazole compounds and s-triazine compounds are particularly suitable.

More suitable are s-triazine derivatives and oxadiazole derivatives having at least one mono-, di- or trihalogen substituted methyl group bound to the s-triazine ring and the oxadiazole ring, respectively. Specific examples include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-i-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromoethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, and the following compounds:

(I)-1

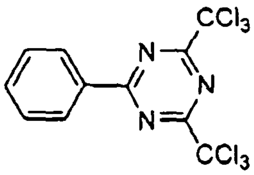

(I)-2

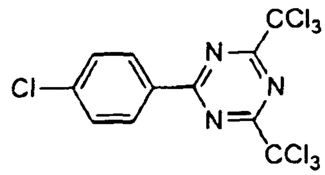

(I)-3

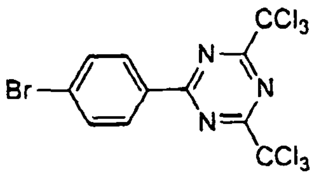

(I)-4

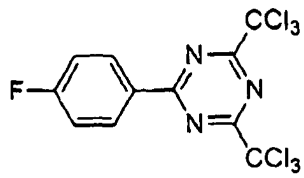

(I)-5

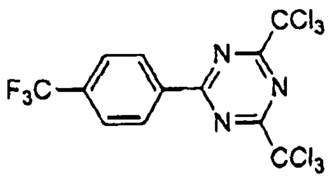

(I)-6

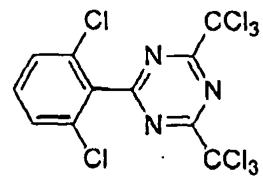

(I)-7

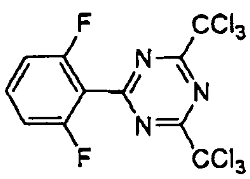

(I)-8

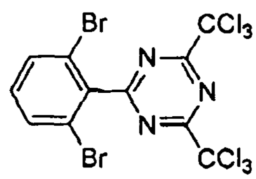

(I)-9

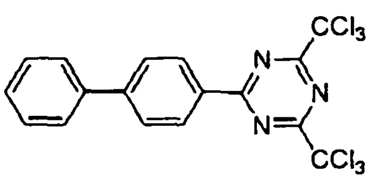

(I)-10

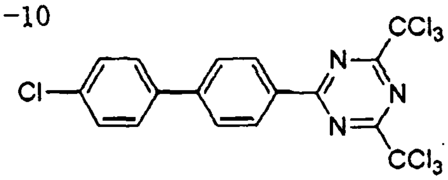

(I)-11

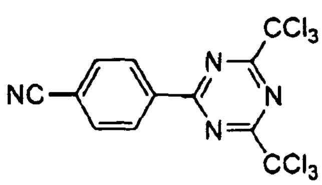

(I)-12

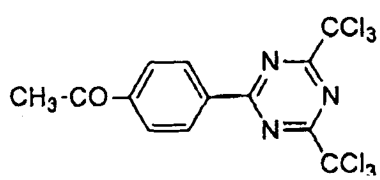

(I)-13

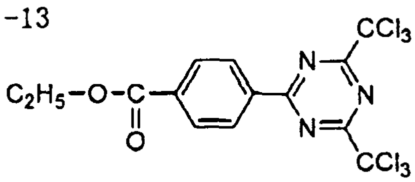

(I)-14

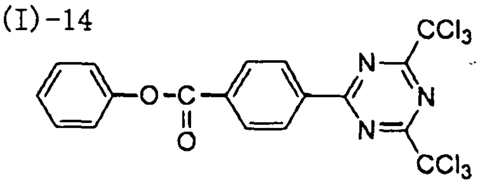

(I)-15

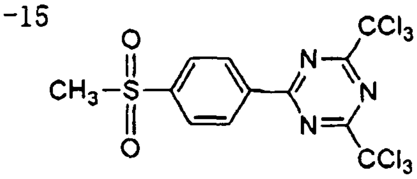

(I)-16

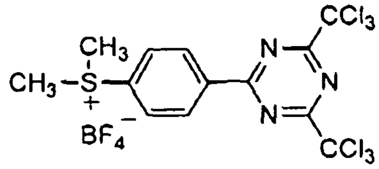

(I)-17

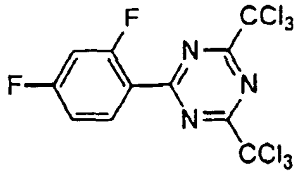

(I)-18

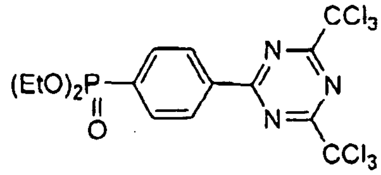

(I)-19

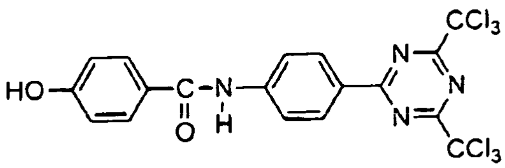

(I)-20

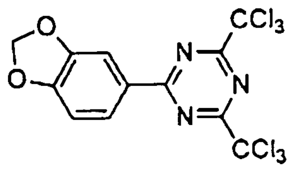

(I)-21

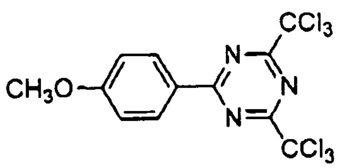

(I)-22

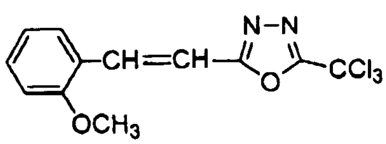

(I)-23

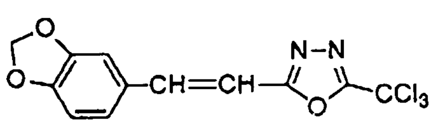

(I)-24

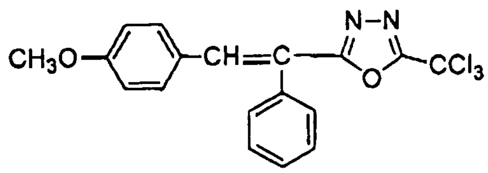

(I)-25

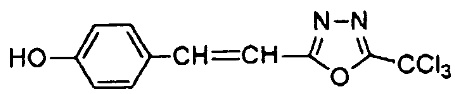

(I)-26

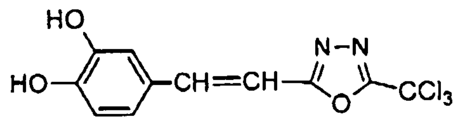

(I)-27

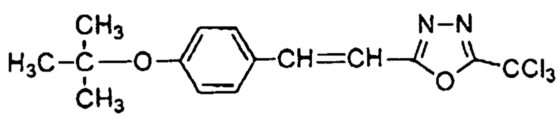

Examples of the carbonyl compound include: benzophenone and its derivatives such as Michler's ketone, 2-methylbenzophenone, 3-methylbenzophenone, 4-methylbenzophenone, 2-chlorobenzophenone, 4-bromobenzophenone and 2-carboxybenzophenone; acetophenone derivatives such as 2,2-dimethoxy-2-phenylacetophenone, 2,2-diethoxyacetophenone, 1-hydroxycyclohexylphenylketone, α-hydroxy-2-methylphenylpropanone, 1-hydroxy-1-methylethyl-(p-isopropylphenyl)ketone, 1-hydroxy-1-(p-dodecylphenyl)ketone, 2-methyl-(4'-(methylthio)phenyl)-2-morpholino-1-propanone and 1,1,1-trichloromethyl-(p-butylphenyl)ketone; thioxanthone and its derivatives such as 2-ethylthioxanthone, 2-isopropylthioxanthone, 2-chlorothioxanthone, 2,4-dimethylthioxanthone, 2,4-diethylthioxanthone and 2,4-diisopropylthioxanthone; and benzoate derivatives such as p-dimethylaminobenzoic acid ethyl ester and p-diethylaminobenzoic acid ethyl ester.

Examples of the azo-based compound that can be used are the azo compounds described in JP 8-108621 A.

Examples of the organic peroxides include, but are not limited to, trimethylcyclohexanone peroxide, acetylacetone peroxide, 1,1-bis(tert-butylperoxy)-3,3,5-trimethylcyclohexane, 1,1-bis(tert-butylperoxy)cyclohexane, 2,2-bis (tert-butylperoxy)butane, tert-butylhydroperoxide, cumene hydroperoxide, diisopropylbenzene hydroperoxide, 2,5-dimethylhexane-2,5-dihydroperoxide, 1,1,3,3-tetramethylbutylhydroperoxide, tert-butylcumylperoxide, dicumyl peroxide, 2,5-dimethyl-2,5-di(tert-butylperoxy)hexane, 2,5-oxanoylperoxide, succinic peroxide, benzoyl peroxide, 2,4-dichlorobenzoylperoxide, diisopropyl peroxydicarbonate, di-2-ethylhexylperoxydicarbonate, di-2-ethoxyethylperoxydicarbonate, dimethoxyisopropylperoxycarbonate, di(3-methyl-3-methoxybutyl)peroxydicarbonate, tert-butylperoxyacetate, tert-butylperoxypivalate, tert-butylperoxyneodecanoate, tert-butylperoxyoctanoate, tert-butylperoxylaurate, tersil carbonate, 3,3',4,4'-tetrakis(t-butylperoxycarbonyl)benzophenone, 3,3',4,4'-tetrakis(t-hexylperoxycarbonyl) benzophenone, 3,3',4,4'-tetrakis(p-isopropylcumylperoxycarbonyl)benzophenone, carbonyldi(t-butylperoxydihydrogendiphthalate) and carbonyldi(t-hexylperoxydihydrogendiphthalate).

Examples of the metallocene compound include the various titanocene compounds described in JP 59-152396 A, JP 61-151197 A, JP 63-41484 A, JP 2-249 A, JP 2-4705 A and JP 5-83588 A, such as di-cyclopentadienyl-Ti-bis-phenyl, di-cyclopentadienyl-Ti-bis-2,6-difluorophen-1-yl, di-cyclopentadienyl-Ti-bis-2,4-difluorophen-1-yl, di-cyclopentadienyl-Ti-bis-2,4,6-trifluorophen-1-yl, di-cyclopentadienyl-Ti-bis-2,3,5,6-tetrafluorophen-1-yl, di-cyclopentadienyl-Ti-bis-2,3,4,5,6-pentafluorophen-1-yl, di-methylcyclopentadienyl-Ti-bis-2,6-difluorophen-1-yl, di-methylcyclopentadienyl-Ti-bis-2,4,6-trifluorophen-1-yl, di-methylcyclopentadienyl-Ti-bis-2,3,5,6-tetrafluorophen-1-yl, di-methylcyclopentadienyl-Ti-bis-2,3,4,5,6-pentafluorophen-1-yl, and the iron-arene complexes described in JP 1-304453 A and

JP 1-152109 A.

The hexaarylbiimidazole compound may be exemplified by the various compounds as described in JP 6-29285 B, US 3,479,185 B, US 4,311,783 B, US 4,622,286 B, etc. and specific examples include 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetrakis(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, 2,2'-bis(o-trifluorophenyl)-4,4',5,5'-tetraphenylbiimidazole, etc.

Examples of the organoboron compound include, but are not limited to, the organic borates as described in JP 62-193044 A, JP 62-150242 A, JP 9-188685 A, JP 9-188686 A, JP 9-188710 A, JP 2000-131837 A, JP 2002-107916 A, JP 2764769 B, JP 2002-116539 A and Kunz, Martin, Rad Tech '98. Proceeding, April 19-22, 1998, Chicago, the organoboron sulfonium complexes or organoboron oxosulfonium complexes described in JP 6-157623 A, JP 6-175564 A and JP 6-175561 A, the organoboron iodonium complexes described in JP 6-175554 A and JP 6-175553 A, the organoboron phosphonium complex described in JP 9-188710 A, and the organoboron transition metal coordination complexes as described in JP 6-348011 A, JP 7-128785 A, JP 7-140589 A, JP 7-306527 A and JP 7-292014 A.

Examples of the disulfone compound include the compounds described in JP 61-166544 A, JP 2003-328465 A, etc.

The oxime ester compound is exemplified by the compounds described in J.C.S. Perkin II (1979) 1653-1660, J.C.S. Perkin II (1979) 156-162, Journal of Photopolymer Science and Technology (1995) 202-232 and JP 2000-66385 A, the compound described in JP 2000-80068 A, and specific examples include the compounds represented by the following structural formulas:

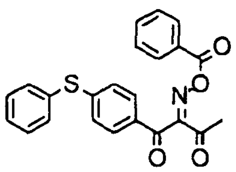 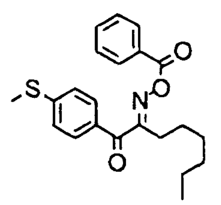 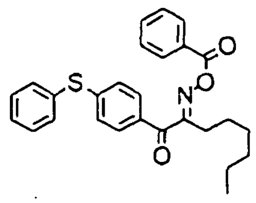 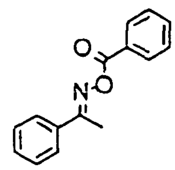 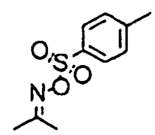

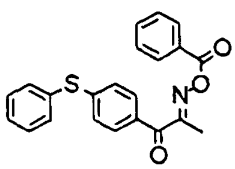 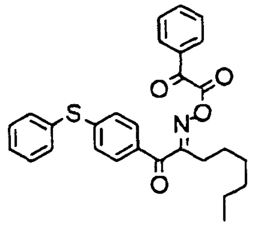 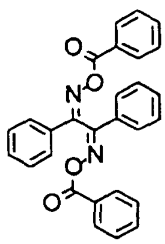 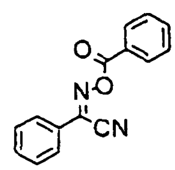 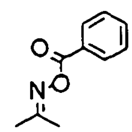

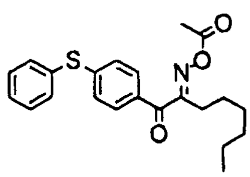 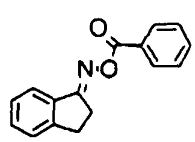 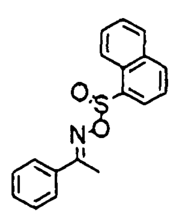 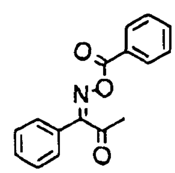 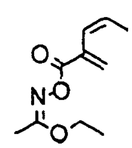

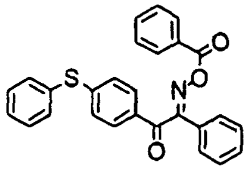
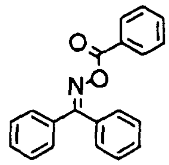
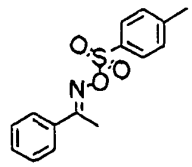
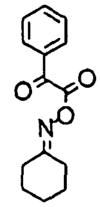
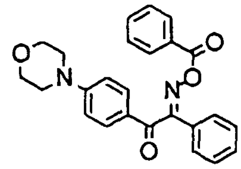

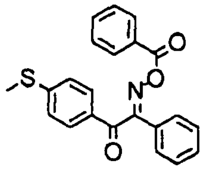
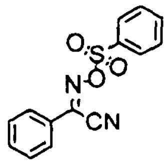

Examples of the onium salt compound include, but are not limited to, the diazonium salts described in S.I. Schlesinger, Photogr. Sci. Eng., 18, 387 (1974) and T.S. Bal et al., Polymer, 21, 423 (1980), the ammonium salts described in US 4,069,055 B, JP 4-365049 A, etc., the phosphonium salts described in US 4,069,055 B and US 4,069,056 B, the iodonium salts described in EP 104,143 B, US 339,049 B, US 410,201 B, JP 2-150848 A and JP 2-296514 A, the sulfonium salts described in EP 370,693 B, EP 390,214 B, EP 233,567 B, EP 297,443 B, EP 297,442 B, US 4,933,377 B, US 161,811 B, US 410,201 B, US 339,049 B, US 4,760,013 B, US 4,734,444 B, US 2,833,827 B, DE 2,904,626 B, DE 3,604,580 B and DE 3,604,581 B, the selenonium salts described in J.V. Crivello et al., Macromolecules, 10(6), 1307 (1977) and J.V. Crivello et al., J. Polymer Sci., Polymer Chem. Ed., 17, 1047 (1979), and the arsonium salts described in C.S. Wen et al., Tech. Proc. Conf. Rad. Curing ASIA, p. 478, Tokyo, October (1988).

In the present invention, the onium salts described above function not as acid generators but as ionic radical polymerization initiators.

The onium salts that are suitably used in the present invention are those which are represented by the following general formulas (RI-I) to (RI-III):

$$Ar_{11}-\overset{+}{N}\equiv N \qquad Z_{11}^{-} \qquad (RI-I)$$

$$Ar_{21}-\overset{+}{I}-Ar_{22} \qquad Z_{21}^{-} \qquad (RI-II)$$

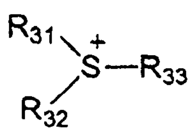

$Z_{31}^{-}$ (RI-III)

In the formula (RI-I), $Ar_{11}$ represents an aryl group with up to 20 carbon atoms which may have 1 to 6 substituents, and preferred substituents include an alkyl group with 1 to 12 carbon atoms, an alkenyl group with 1 to 12 carbon atoms, an alkynyl group with 1 to 12 carbon atoms, an aryl group with 1 to 12 carbon atoms, an alkoxy group with 1 to 12 carbon atoms, an aryloxy group with 1 to 12 carbon atoms, a halogen atom, an alkylamino group with 1 to 12 carbon atoms, a dialkylamino group with 1 to 12 carbon atoms, an alkylamide or arylamide group with 1 to 12 carbon atoms, a carbonyl group, a carboxyl group, a cyano group, a sulfonyl group, a thioalkyl group with 1 to 12 carbon atoms, and a thioaryl group with 1 to 12 carbon atoms; $Z_{11}^{-}$ represents a monovalent anion and specific examples include a halide ion, a perchlorate ion, a hexafluorophosphate ion, a tetrafluoroborate ion, a sulfonate ion, a sulfinate ion, a thiosulfonate ion and a sulfate ion; among these, a perchlorate ion, a hexafluorophosphate ion, a tetrafluoroborate ion, a sulfonate ion and a sulfinate ion are particularly preferred from the viewpoint of stability.

In the formula (RI-II), $Ar_{21}$ and $Ar_{22}$ each independently represent an aryl group with up to 20 carbon atoms which may have 1 to 6 substituents, and preferred substituents include an alkyl group with 1 to 12 carbon atoms, an alkenyl group with 1 to 12 carbon atoms, an alkynyl group with 1 to 12 carbon atoms, an aryl group with 1 to 12 carbon atoms, an alkoxy group with 1 to 12 carbon atoms, an aryloxy group with 1 to 12 carbon atoms, a halogen atom, an alkylamino group with 1 to 12 carbon atoms, a dialkylamino group with 1 to 12 carbon atoms, an alkylamide or arylamide group with 1 to 12 carbon atoms, a carbonyl group, a carboxyl group, a cyano group, a sulfonyl group, a thioalkyl group with 1 to 12 carbon atoms, and a thioaryl group with 1 to 12 carbon atoms; $Z_{21}^-$ represents a monovalent anion and specific examples include a halide ion, a perchlorate ion, a hexafluorophosphate ion, a tetrafluoroborate ion, a sulfonate ion, a sulfinate ion, a thiosulfonate ion and a sulfate ion; among these, a perchlorate ion, a hexafluorophosphate ion, a tetrafluoroborate ion, a sulfonate ion, a sulfinate ion and a carboxylate ion are particularly preferred from the viewpoints of stability and reactivity.

In the formula (RI-III), $R_{31}$, $R_{32}$ and $R_{33}$ each independently represent an aryl, alkyl, alkenyl or alkynyl group with up to 20 carbon atoms which may have 1 to 6 substituents; among these, an aryl group is particularly preferred from the viewpoints of reactivity and stability; exemplary substituents include an alkyl group with 1 to 12 carbon atoms, an alkenyl group with 1 to 12 carbon atoms, an alkynyl group with 1 to 12 carbon atoms, an aryl group with 1 to 12 carbon atoms, an alkoxy group with 1 to 12 carbon atoms, an aryloxy group with 1 to 12 carbon atoms, a halogen atom, an alkylamino group with 1 to 12 carbon atoms, a dialkylamino group with 1 to 12 carbon atoms, an alkylamide or arylamide group with 1 to 12 carbon atoms, a carbonyl group, a carboxyl group, a cyano group, a sulfonyl group, a thioalkyl group with 1 to 12 carbon atoms, and a thioaryl group with 1 to 12 carbon atoms; $Z_{31}^-$ represents a monovalent anion and specific examples include a halide ion, a perchlorate ion, a hexafluorophosphate ion, a tetrafluoroborate ion, a sulfonate ion, a sulfinate ion, a thiosulfonate ion and a sulfate ion; among these, a perchlorate ion, a hexafluorophosphate ion, a tetrafluoroborate ion, a sulfonate ion, a sulfinate ion and a carboxylate ion are particularly preferred from the viewpoints of stability and reactivity; more preferred are the carboxylate ions described in JP 2001-343742 A, and particularly preferred are the carboxylate ions described in JP 2002-148790 A.

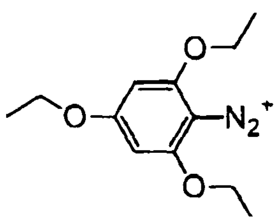 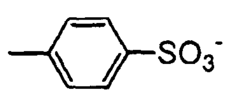 (N-1)

$PF_6^-$ (N-2)

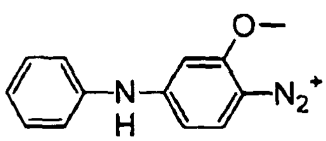 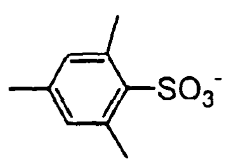 (N-3)

$ClO_4^-$ (N-4)

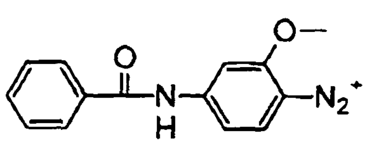 $CF_3SO_3^-$ (N-5)

$BF_4^-$ (N-6)

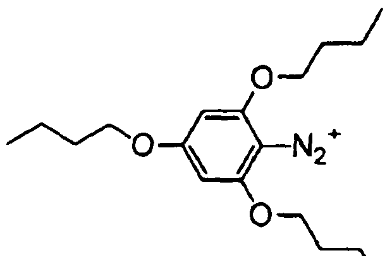
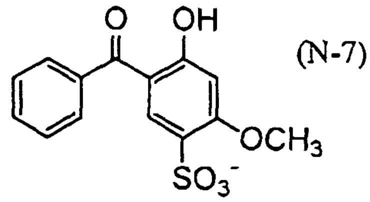

(N-7)

$ClO_4^-$ (N-8)

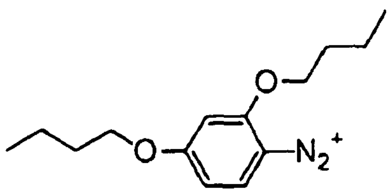
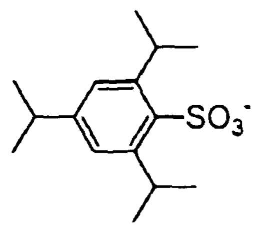

(N-9)

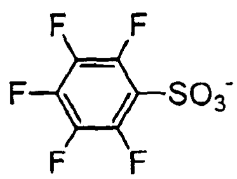

(N-10)

$PF_6^-$ (N-11)

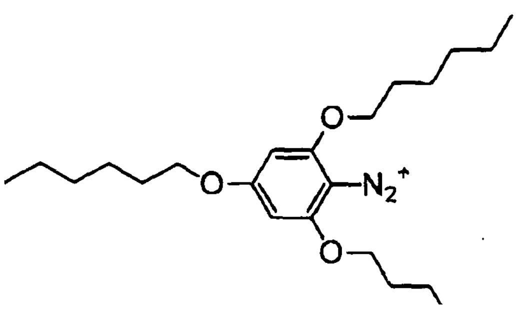
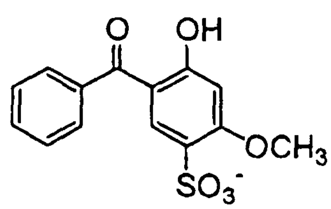

(N-12)

$ClO_4^-$ (N-13)

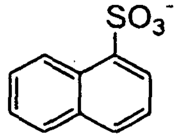 (N-14)

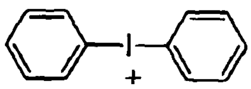 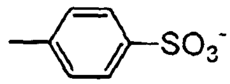 (I-1)

$PF_6^-$ (I-2)

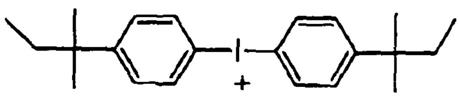 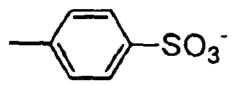 (I-3)

$ClO_4^-$ (I-4)

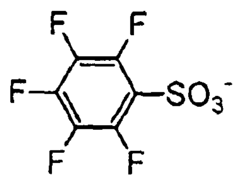 (I-5)

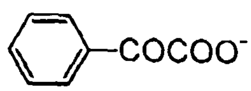 (I-6)

$CF_3SO_3^-$ (I-7)

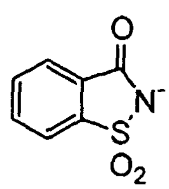 (I-8)

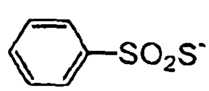 (I-9)

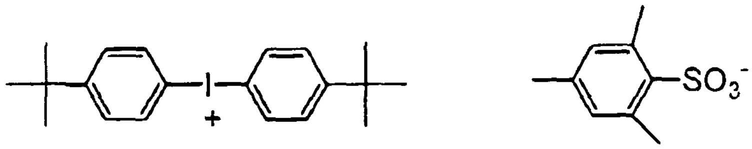

(I-10)

$ClO_4^-$ (I-11)

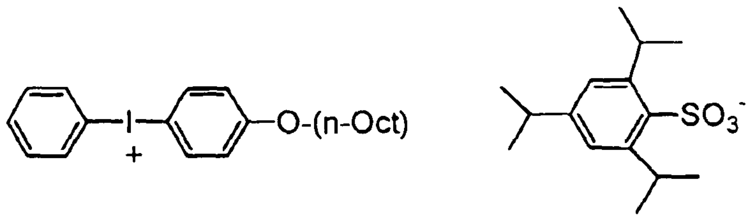

(I-12)

$CF_3COO^-$ (I-13)

$CF_3SO_3^-$ (I-14)

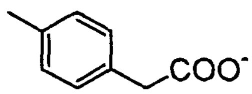

(I-15)

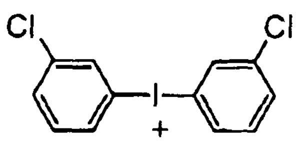

$BF_4^-$ (I-16)

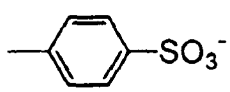

(I-17)

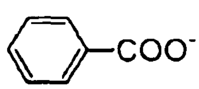

(I-18)

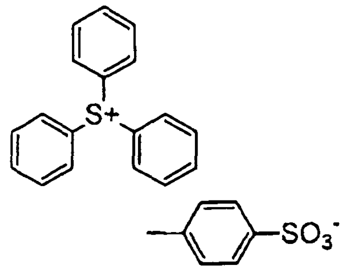
(S-1)

$PF_6^-$ (S-2)

$ClO_4^-$ (S-3)

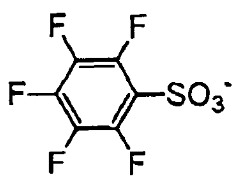
(S-4)

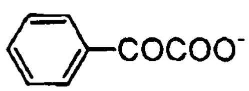
(S-5)

$CF_3SO_3^-$ (S-6)

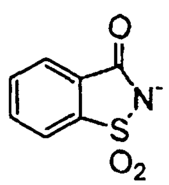
(S-7)

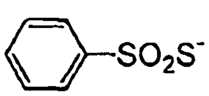
(S-8)

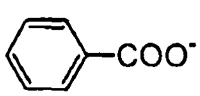
(S-9)

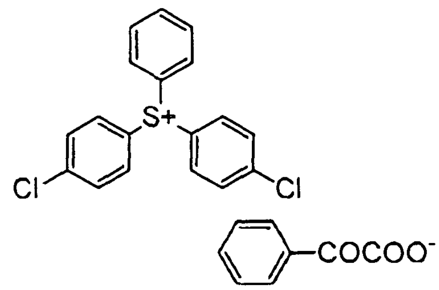
(S-10)

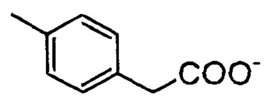
(S-11)

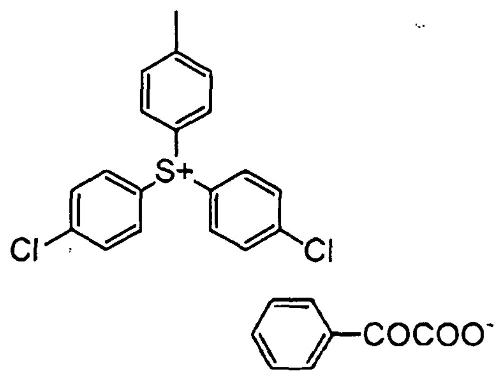
(S-12)

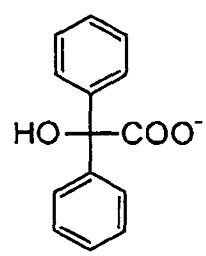
(S-13)

$BF_4^-$ (S-14)

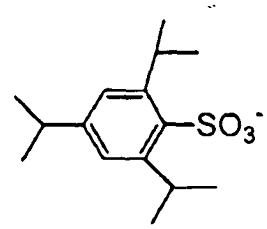
(S-15)

The polymerization initiator is not limited to the examples given above but particularly from the viewpoints of reactivity and stability, the triazine-based initiators, organohalogen compounds, oxime ester compounds, diazonium salts, iodonium salts and sulfonium salts are preferred since they generate radicals in large quantities as a result of short exposure.

It should be further mentioned that those triazine-based initiators and polymerization initiators based on the organohalogen compounds, oxime ester compounds, diazonium salts, iodonium salts and sulfonium salts are preferably used in combination with sensitizers. The use of those initiators in combination with sensitizers results in increased rate of photopolymerization.

Specific examples of such sensitizers include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthone, benzil, dibenzalacetone, p-(dimethylamino)phenylstyrylketone, p-(dimethylamino)phenyl-p-methylstyrylketone, benzophenone, p-(dimethylamino)benzophenone (or Michler's ketone), p-(diethylamino)benzophenone, benzanthrone, etc.

Preferred sensitizers for use in the present invention include the compound of general formula (I) that is described in JP 51-48516 B:

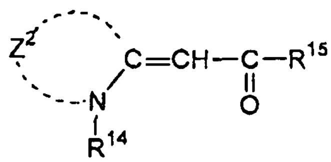

(I)

wherein $R^{14}$ represents an alkyl group (e.g. methyl, ethyl or propyl) or a substituted alkyl group (e.g. 2-hydroxyethyl, 2-methoxyethy, carboxymethyl or 2-carboxyethyl); $R^{15}$ represents an alkyl group (e.g. methyl or ethyl) or an aryl group (e.g. phenyl, p-hydroxyphenyl, naphthyl or thienyl); $Z^2$ represents the nonmetallic atomic group necessary to form a nitrogenous heterocyclic nucleus commonly used in cyanine dyes, as exemplified by benzothiazoles (e.g. benzothiazole, 5-chlorobenzothiazole and 6-chlorobenzothiazole), naphthothiazoles (e.g. α-naphthothiazole and β-naphthothiazole), benzoselenazoles (e.g. benzoselenazole, 5-chlorobenzoselenazole and 6-methoxybenzoselenazole), naphthoselenazoles (e.g. α-naphthoselenazole and β-naphthoselenazole), benzoxazoles (e.g. benzoxazole, 5-methylbenzoxazole and 5-phenylbenzoxazole), and naphthoxazoles (e.g. α-naphthoxazole and β-naphthoxazole).

Specific examples of the compound represented by general formula (I) are those having chemical structures comprising various combinations of $Z^2$, $R^{14}$ and $R^{15}$ and many of them are available as known substances. Therefore, the compound (I) can appropriately be chosen from those known substances. Other preferred sensitizers for use in the present invention include the merocyanine dyes described in JP 5-47095 B and JP 2000-147763 A, as well as the ketocoumarin-based compound represented by the following general formula (II):

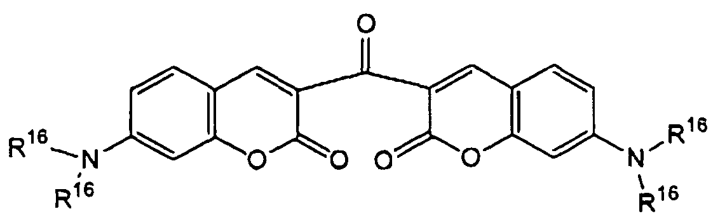

(II)

wherein $R^{16}$ represents an alkyl group such as methyl or ethyl.

The polymerization initiators and the sensitizers described above are each preferably added in an amount of 0.1 to 50 wt%, more preferably of 0.5 to 30 wt%, and most preferably of 0.8 to 20 wt%, of the total solids in the image recording layer. If they are added in amounts within the stated ranges, the image recording layer has not only satisfactory sensitivity but it also exhibits reasonable resistance to scumming in the nonimage areas during printing. The polymerization initiators described above may be used either alone or in admixture of themselves. Such polymerization initiators may be added to the same layer that contains other components or they may be added in a different layer.

<(B) Polymerizable compound>

The polymerizable compound that can be used in the present invention is an addition polymerizable compound having at least one ethylenically unsaturated double bond and it is selected from among compounds having at least one, preferably at least two, ethylenically unsaturated bonds. The group of such compounds are known widely in the industrial field of interest and can be used without particular limitation in the present invention. These compounds have a variety of chemical morphologies including, for example, monomers, prepolymers, i.e., dimers, trimers and oligomers,

as well as mixtures thereof and copolymers thereof. Exemplary monomers and copolymers thereof include unsaturated carboxylic acids (e.g. acrylic acid, methacrylic acid, itaconic acid, crotonic acid, isocrotonic acid and maleic acid), as well as esters and amides thereof; preferably used are esters of unsaturated carboxylic acids and aliphatic polyol compounds, and amides of unsaturated carboxylic acids and aliphatic polyamine compounds. Also useful with advantage are the products of addition reaction of unsaturated carboxylic acid esters or amides having nucleophilic substituents such as hydroxyl, amino and mercapto groups with mono- or polyfunctional isocyantes or epoxies, as well as the products of their dehydrocondensation reaction with mono- or polyfunctional carboxylic acids. Other suitable examples are the products of addition reaction of unsaturated carboxylic acid esters or amides having electrophilic substituents such as isocyanate or epoxy groups with mono- or polyfunctional alcohols, amines or thiols, as well as the products of substitution reaction of unsaturated carboxylic acid esters or amides having eliminating substituents such as halogen or tosyloxy groups with mono- or polyfunctional alcohols, amines or thiols. Alternatively, it is possible to use a group of compounds in which the unsaturated carboxylic acids mentioned above are replaced by unsaturated phosphonic acids, styrenes, vinyl ethers, etc.

Let us first describe the monomeric esters of aliphatic polyol compounds and unsaturated carboxylic acids. Specific examples of acrylate esters are ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tris(acryloyloxypropyl)ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tris(acryloyloxyethyl)isocyanurate, polyester acrylate oligomers, isocyanuric acid EO modified triacrylate, etc.

Specific examples of methacrylate esters are tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, bis[p-(methacryloxyethoxy)phenyl]dimethylmethane, etc.

Specific examples of itaconate esters are ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc. Specific examples of crotonate esters are ethylene glycol dicrotonate, tetramethylene glycol dicrotonate, pentaerythritol dicrotonate, sorbitol tetradicrotonate, etc. Specific examples of isocrotonate esters are ethylene glycol diisocrotonate, pentaerythritol diisocrotonate, sorbitol tetraisocrotonate, etc. Specific examples of maleate esters are ethylene glycol dimaleate, triethylene glycol dimaleate, pentaerythritol dimaleate, sorbitol tetramaleate, etc.

Other esters that are suitable for use may be exemplified by the aliphatic alcoholic esters described in JP 51-47334 B and JP 57-196231 A, those having aromatic skeletons which are described in JP 59-5240 A, JP 59-5241 A and JP 2-226149 A, and those having amino groups which are described in JP 1-165613 A. These and other monomeric esters described above may be used in admixture.

Specific examples of the monomeric amides of aliphatic polyamine compounds and unsaturated carboxylic acids are methylene bis-acrylamide, methylene bis-methacrylamide, 1,6-hexamethylene bis-acrylamide, 1,6-hexamethylene bis-methacrylamide, diethylenetriamine tris-acrylamide, xylylene bis-acrylamide, xylylene bis-methacrylamide, etc. Other preferred amide-based monomers include those having a cyclohexylene structure which are described in JP 54-21726 B.

Also suitable for use are urethane-based addition polymerizable compounds that are produced by the addition reaction between an isocyanate and a hydroxyl group. Specific examples include vinyl urethane compounds containing at least two polymerizable vinyl groups in the molecule which have a hydroxyl containing vinyl monomer of the following general formula (III) added to a polyisocyanate compound having at least two isocyanate groups in the molecule, as described in JP 48-41708 B:

$$CH_2=C(R_4)COOCH_2CH(R_5)OH \quad \text{(III)}$$

(where $R_4$ and $R_5$ each represent H or $CH_3$).

Other suitable examples are urethane acrylates of the types described in JP 51-37193 A, JP 2-32293 B and JP 2-16765 B and the urethane compounds having an ethylene oxide-based skeleton which are described in JF 58-49860 B, JP 56-17654 B, JP 62-39417 B, and JP 62-39418 B. Using the addition polymerizable compounds having an amino structure or a sulfide structure in the molecule which are described in JP 63-277653 A, JP 63-260909 A and JP 1-105238 A, one can produce photopolymerizable compositions having very fast photosensitivity.

Other examples may include polyfunctional acrylates and methacrylates such as polyester acrylates and epoxy acrylates produced by reacting epoxy resins with (meth)acrylic acid, as described in JP 48-64183 A, JP 49-43191 B and JP 52-30490 B. Still other examples may include the particular unsaturated compounds described in JP 46-43946 B, JP 1-40337 B and JP 1-40336 B, as well as the vinylphosphonic acid-based compounds described in JP 2-25493 A. In certain cases, those having the structure described in JP 61-22048 A containing a perfluoroalkyl group are used with advantage. Further useful are the compounds that are introduced as photocurable monomers and oligomers in Journal of The Adhesion Society of Japan, Vol. 20, No. 7, pp. 300-308 (1984).
Details about the usage of the polymerizable compounds described above, such as their preferred structure upon use, whether they should be used alone or in combination, and the amount of their addition can be determined in a desired manner in accordance with the performance design eventually required for the presensitized plate. The following are typical criteria for selection.
In terms of sensitivity, it is preferred to adopt a structure having a high content of unsaturated groups per molecule and, in most cases, bi- and higher functionality is preferred. In order to enhance the strength of the image areas or the hardened layer, tri- and higher functionality is better. Also effective is a method of adjusting both sensitivity and strength by combining compounds having different functionalities and different polymerizable groups (as exemplified by acrylate esters, methacrylate esters, styrenic compounds, and vinyl ether compounds).
The choice and usage of the polymerizable compounds is also an important factor for their miscibility with and dispersibility in other ingredients (e.g. the binder polymer, initiator, colorant, etc.) in the image recording layer; for instance, miscibility can occasionally be improved by using low-purity compounds or combining two or more compounds. If desired, with a view to improving the adhesion of the substrate, as well as the protective layer and other components to be described later, a particular structure may occasionally be chosen.
The polymerizable compounds are used in amounts that preferably range from 5 to 80 wt%, more preferably from 25 to 75 wt%, of the total solids in the image recording layer. Those polymerizable compounds may be used either alone or in combination. Other factors that affect the usage of the addition polymerizable compounds are the degree of inhibition of polymerization by oxygen, resolution, fogging, change in refractive index, surface tackiness, etc. and the structure, formulation and amount of addition can be selected as appropriate in view of such factors; in certain cases, special layer compositions and coating methods for applying the undercoat and/or topcoat can also be adopted.

<(C) Binder polymer>

In the present invention, a binder polymer can be used for the purpose of improving the strength and film performance of the image recording layer and the adaptability for on-press development. Any known binder polymers can be used without limitation and linear organic polymers having good filming property are preferred. Examples of such binder polymers include acrylic resins, poly(vinyl acetal) resins, polyurethane resins, polyurea resins, polyimide resins, polyamide resins, epoxy resins, methacrylic resins, polystyrenic resins, novolak phenolic resins, polyester resins, synthetic rubber, and natural rubber.
The binder polymer has preferably a crosslinking property for providing a stronger layer in the image areas. In order that the binder polymer has a crosslinking property, one needs only to introduce crosslinking functional groups such as ethylenically unsaturated bonds into the principal chain or side chains of the macromolecule. The crosslinking functional groups may be introduced by copolymerization.
Examples of a polymer having ethylenically unsaturated bonds in the principal chain of the molecule include poly-1,4-butadiene and poly-1,4-isoprene.
Examples of a polymer having ethylenically unsaturated bonds in side chains of the molecule include polymers of acrylic or methacrylic acid esters or amides, in which an ester or amide residue (R in -COOR or -CONHR) has ethylenically unsaturated bonds.
Examples of the residue having ethylenically unsaturated bonds (as represented by R above) include $-(CH_2)_nCR^1=CR^2R^3$, $-(CH_2O)_nCH_2CR^1=CR^2R^3$, $-(CH_2CH_2O)_nCH_2CR^1=CR^2R^3$, $-(CH_2)_nNH-CO-O-CH_2CR^1=CR^2R^3$, $-(CH_2)_n-O-CO-CR^1=CR^2R^3$ and $-(CH_2CH_2O)_2-X$ (where $R^1$, $R^2$ and $R^3$ each represent a hydrogen atom, a halogen atom or an alkyl, aryl, alkoxy or aryloxy group having 1 to 20 carbon atoms, provided that $R^1$ and $R^2$ or $R^3$ may combine to form a ring; n represents an integer of 1 to 10; X represents a dicyclopentadienyl residue).
Specific examples of the ester residue include $-CH_2CH=CH_2$ (described in JP 7-21633 B), $-CH_2CH_2O-CH_2CH=CH_2$, $-CH_2C(CH_3)=CH_2$, $-CH_2CH=CH-C_6H_5$, $-CH_2CH_2OCOCH=CH-C_6H_5$, $-CH_2CH_2-NH-COO-CH_2CH=CH_2$ and $-CH_2CH_2O-X$ (where X represents a dicyclopentadienyl residue).
Specific examples of the amide residue include $-CH_2CH=CH_2$, $-CH_2CH_2-Y$ (where Y represents a cyclohexene residue), and $-CH_2CH_2-OCO-CH=CH_2$.
The binder polymer having a crosslinking property may harden by the following mechanism: a free radical (a polymerization initiating radical or a radical growing in the process of polymerization of the polymerizable compound) is attached to a crosslinking functional group in the binder polymer and addition polymerization takes place between

the polymer molecules either directly or via the polymerization cascade of the polymerizable compound, whereby bridges are formed between the polymer molecules, causing the binder polymer to harden. Alternatively, an atom in the polymer (for example, a hydrogen atom on the carbon atom adjacent to the functional crosslinking group) is extracted by a free radical to generate polymer radicals, which are combined together to form bridges between the polymer molecules, causing the binder polymer to harden.

The content of crosslinking groups in the binder polymer (the content of radical polymerizable unsaturated double bonds as measured by iodine titration) is preferably in the range of 0.1 to 10.0 mmol, more preferably of 1.0 to 7.0 mmol, and most preferably of 2.0 to 5.5 mmol, per gram of the binder polymer. It is within those ranges that satisfactory sensitivity and good storage stability are both obtained.

From the viewpoint of controlling the efficiency with which the unexposed areas of the image recording layer are processed by on-press development, the binder polymer has preferably high solubility or dispersibility in ink and/or a fountain solution.

In order to improve the solubility or dispersibility in ink, the binder polymer is preferably oleophilic, but in order to improve the solubility or dispersibility in a fountain solution, the binder polymer is preferably hydrophilic. Hence, using two binder polymers in combination, one being oleophilic and the other hydrophilic, is also effective in the present invention.

Suitable examples of the hydrophilic binder polymer are those having hydrophilic groups such as a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonic acid group, a phosphoric acid group, etc.

Specific examples include gum arabic, casein, gelatin, starch derivatives, carboxymethyl cellulose and its sodium salt, cellulose acetate, sodium alginate, vinyl acetate-maleic acid copolymers, styrene-maleic acid copolymers, polyacrylic acids and their salts, polymethacrylic acids and their salts, homopolymers and copolymers of hydroxyethyl methacrylates, homopolymers and copolymers of hydroxyethyl acrylates, homopolymers and copolymers of hydroxypropyl methacrylates, homopolymers and copolymers of hydroxypropyl acrylates, homopolymers and copolymers of hydroxybutyl methacrylates, homopolymers and copolymers of hydroxybutyl acrylates, polyethylene glycols, hydroxypropylene polymers, polyvinyl alcohols, hydrolyzed poly(vinyl acetate) which is at least 60 mol%, preferably at least 80 mol%, hydrolyzed, poly(vinyl formal), poly(vinyl butyral), poly(vinylpyrrolidone), homopolymers and copolymers of acrylamides, homopolymers and copolymers of methacrylamides, homopolymers and copolymers of N-methylolacrylamide, alcohol soluble nylon, polyethers of 2,2-bis-(4-hydroxyphenyl)-propane and epichlorohydrin.

The binder polymer has preferably a weight-average molecular weight of at least 5,000, more preferably of 10,000 to 300,000, and a number-average molecular weight of at least 1,000, more preferably of 2,000 to 250,000. The polydispersity (weight-average molecular weight/number-average molecular weight) is preferably between 1.1 and 10.

The binder polymer may be a random polymer, a block polymer, a graft polymer or any other type but a random polymer is preferred.

The binder polymer can be synthesized by known methods. Various solvents may be used for the synthesis and they include, for example, tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water. These solvents may be used either alone or in admixture of two or more thereof.

A radical polymerization initiator may be used to synthesize the binder polymer and known compounds can be used, as exemplified by azo-based initiators and peroxide initiators.

The binder polymers may be used either alone or in admixture of two or more thereof.

The content of the binder polymer is preferably in the range of 10 to 90 wt%, more preferably of 20 to 80 wt%, and most preferably of 30 to 70 wt%, of the total solids in the image recording layer. It is within those ranges that the image areas have satisfactory strength and image-forming capability.

In addition, (B) polymerizable compound and (C) binder polymer are preferably used in such amounts that the weight ratio of the former to the latter is between 1:9 and 7:3.

<Other ingredients in the image recording layer>

The image recording layer in the present invention may, depending on the need, contain other additives including surfactants, colorants, print-out agents, polymerization inhibitors, higher fatty acids or their derivatives, plasticizers, fine inorganic particles and low-molecular weight hydrophilic compounds. These optional additives are described below.

<Surfactant>

In the present invention, surfactants are preferably used in the image recording layer for the purpose of enhancing on-press developability at the start of printing and for improving the surface state of the image recording layer applied to the support. Surfactants may be nonionic, anionic, cationic, amphoteric, fluorine-based, and so on. These surfactants may be used either alone or in combination of two or more thereof.

The nonionic surfactants for use in the present invention are not limited in any particular way and those which are known can be employed. Examples include polyoxyethylene alkyl ethers, polyoxyethylene alkylphenyl ethers, polyoxyethylene polystyrylphenyl ethers, polyoxyethylene-polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylene esters of castor oil, polyoxyethylene glycerol fatty acid partial esters, fatty acid diethanolamides, N,N-bis-2-hyhdroxyalkylamines, polyoxyethylene alkylamines, triethanolamine fatty acid esters, trialkylamine oxides, poly(ethylene glycol), and copolymers of poly(ethylene glycol) and poly(propylene glycol).

The anionic surfactants for use in the present invention are not limited in any particular way and those which are known can be employed. Examples include fatty acid salts, abietic acid salts, hydroxyalkanesulfonic acid salts, alkanesulfonic acid salts, dialkylsulfosuccinic ester salts, linear alkylbenzenesulfonic acid salts, branched alkylbenzenesulfonic acid salts, alkylnaphthalenesulfonic acid salts, alkylphenoxypolyoxyethylene propylsulfonic acid salts, polyoxyethylene alkylsulfophenyl ether salts, N-methyl-N-oleyltaurine sodium salt, N-alkylsulfosuccinic monoamide disodium salts, petroleum sulfonic acid salts, sulfated tallow oil, sulfuric ester salts of fatty acid alkyl esters, alkylsulfuric acid ester salts, polyoxyethylene alkylether sulfuric acid ester salts, fatty acid monoglyceride sulfuric acid ester salts, polyoxyethylene alkylphenylether sulfuric acid ester salts, polyoxyethylene styrylphenylether sulfuric acid ester salts, alkylphosphoric acid ester salts, polyoxyethylene alkylether phosphoric acid ester salts, polyoxyethylene alkylphenylether phosphoric acid ester salts, partially saponified styrene/maleic anhydride copolymers, partially saponified olefin/maleic anhydride copolymers, and naphthalenesulfonic acid salts condensed with formaldehyde.

The cationic surfactants for use in the present invention are not limited in any particular way and those which are known can be employed. Examples include alkylamine salts, quaternary ammonium salts, polyoxyethylene alkylamine salts, and polyethylene polyamine derivatives.

The amphoteric surfactants for use in the present invention are not limited in any particular way and those which are known can be employed. Examples include carboxybetaines, aminocarboxylic acids, sulfobetaines, aminosulfuric acid esters, and imidazolines.

The term "polyoxyethylene" in the names of the surfactants mentioned above may be replaced by "polyoxyalkylenes" such as polyoxymethylene, polyoxypropylene and polyoxybutylene and surfactants after such replacements can also be used in the present invention.

More preferred surfactants include fluorine-based surfactants containing a perfluoroalkyl group in the molecule. Examples of such fluorine-based surfactants include: an anionic type as exemplified by perfluoroalkylcarboxylic acid salts, perfluoroalkylsulfonic acid salts and perfluoroalkylphosphoric acid esters; an amphoteric type as exemplified by perfluoroalkylbetaines; a cationic type as exemplified by perfluoroalkyl trimethylammonium salts; and a nonionic type as exemplified by perfluoroalkylamine oxides, perfluoroalkylethylene oxide adducts, oligomers containing a perfluoroalkyl group and a hydrophilic group, oligomers containing a perfluoroalkyl group and an oleophilic group, oligomers containing a perfluoroalkyl group, a hydrophilic group and an oleophilic group, and urethanes containing a perfluoroalkyl group and an oleophilic group. Also suitable are the fluorine-based surfactants described in JP 62-170950 A, JP 62-226143 A and JP 60-168144 A.

The surfactants may be used either alone or in combination of two or more thereof.

The surfactants are used in amounts that preferably range from 0.001 to 10 wt%, more preferably from 0.01 to 7 wt%, of the total solids in the image recording layer.

<Colorant>

In the present invention, various compounds other than the ingredients described above may be added as required. For example, dyes having a large absorption in the visible range can be used as image coloring matter. Specific examples include Oil Yellow #101, Oil Yellow #103, Oil Pink #312, Oil Green BG, Oil Blue BOS, Oil Blue #603, Oil Black BY, Oil Black BS and Oil Black T-505 (all being manufactured by Orient Chemical Industries, Ltd.), Victoria pure blue, crystal violet (CI 42555), methyl violet (CI 42535), ethyl violet, Rhodamine B (CI 145170B), malachite green (CI 42000) and methylene blue (CI 52015), as well as the dyes described in JP 62-293247 A. Also suitable for use are pigments such as phthalocyanine-based pigments; azo-based pigments, carbon black, titanium oxide, etc.

These colorants are preferably added since they provide ease in telling the image areas from the nonimage

areas after image formation. The amount of their addition ranges preferably from 0.01 to 10 wt% of the total solids in the image recording material.

<Print-out agent>

In the image recording layer of the present invention, compounds that change color by reaction with acid or radical may be added in order to form printout image. Effective compounds may be exemplified by diphenylmethane dyes, triphenylmethane dyes, thiazine dyes, oxazine dyes, xanthene dyes, anthraquinone dyes, iminoquinone dyes, azo dyes, azomethine dyes, etc.

Specific examples include: dyes such as Brilliant Green, ethyl violet, methyl green, crystal violet, basic fuchsin, methyl violet 2B, quinaldine red, Rose Bengal, methanyl yellow, thymol sulfophthalein, xylenol blue, methyl orange, paramethyl red, Congo Red, benzopurpurin 4B, α-naphthyl red, Nile Blue 2B, Nile Blue A, Methyl Violet, Malachite Green, parafuchsin, Victoria Pure Blue BOH (product of HODOGAYA CHEMICAL Co., Ltd.), Oil Blue #603 (product of Orient Chemical Industries, Ltd.), Oil Pink #312 (product of Orient Chemical Industries, Ltd.), Oil Red 5B (product of Orient Chemical Industries, Ltd.), Oil Scarlet #308 (product of Orient Chemical Industries, Ltd.), Oil Red OG (product of Orient Chemical Industries, Ltd.), Oil Red RR (product of Orient Chemical Industries, Ltd.), Oil Green #502 (product of Orient Chemical Industries, Ltd.), Spiron Red BEH Special (product of HODOGAYA CHEMICAL Co., Ltd.), m-cresol purple, cresol red, Rhodamine B, Rhodamine 6G, Sulfo Rhodamine B, auramine, 4-p-diethylaminophenyliminonaphthoquinone, 2-carboxyanilino-4-p-diethylaminophenyliminonaphthoquinone, 2-carboxystearylamino-4-p-N,N-bis(hydroxyethyl)amino-phenyliminonaphthoquinone, 1-phenyl-3-methyl-4-p-diethylaminophenylimino-5-pyrazolone, and 1-β-naphthyl-4-p-diethylaminophenylimino-5-pyrazolone; and leuco dyes such as p,p',p"-hexamethyltriaminotriphenylmethane (leuco crystal violet) and Pergascript Blue SRB (product of Ciba-Geigy AG).

Aside from the above, leuco dyes known as ingredients for use in thermosensitive paper and pressure-sensitive paper are also suitable. Specific examples include crystal violet lactone, malachite green lactone, benzoyl leuco methylene blue, 2-(N-phenyl-N-methylamino)-6-(N-p-tolyl-N-ethyl)amino-fluoran, 2-anilino-3-methyl-6-(N-ethyl-p-toluidino)fluoran, 3,6-dimethoxyfluoran, 3-(N,N-diethylamino)-5-methyl-7-(N,N-dibenzylamino)-fluoran, 3-(N-cyclohexyl-N-methylamino)-6-methyl-7-anilinofluoran, 3-(N,N-diethylamino)-6-methyl-7-anilinofluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethylamino)-7-(4-chloroanilino)fluoran, 3-(N,N-diethylamino)-7-chlorofluoran, 3-(N,N-diethylamino)-7-benzylaminofluoran, 3-(N,N-diethylamino)-7,8-benzofluoran, 3-(N,N-dibutylamino)-6-methyl-7-anilinofluoran, 3-(N,N-dibutylamino)-6-methyl-7-xylidinofluoran, 3-piperidino-6-methyl-7-anilinofluoran, 3-pyrrolidino-6-methyl-7-anilinofluoran, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxyphenyl)-3-(1-ethyl-2-methylindol-3-yl)-4-diphthalide, and 3-(4-diethylaminophenyl)-3-(1-ethyl-2-methylindol-3-yl)phthalide.

The dyes that change color by reaction with acid or radical are preferably added in amounts that range from 0.01 to 15 wt% of the total solids in the image recording layer.

<Polymerization inhibitor>

A small amount of thermal polymerization inhibitor is preferably added to the image recording layer of the invention in order to prevent unwanted thermal polymerization of (C) radical polymerizable compound during the manufacture or storage of the layer.

Suitable examples of the thermal polymerization inhibitor include hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salt.

The thermal polymerization inhibitor is preferably added in amounts ranging from about 0.01 to about 5 wt% of the total solids in the image recording layer.

<Higher fatty acids or their derivatives>

In order to prevent the retardation of polymerization by oxygen, higher fatty acids such as behenic acid or their derivatives such as behenic acid amide may be added to the image recording layer in the present invention so that they will be localized on the surface of the image recording layer in the process of drying after application to the support. The higher fatty acids or their derivatives are preferably added in amounts ranging from about 0.1 to about 10 wt% of the total solids in the image recording layer.

<Plasticizer>

The image recording layer of the invention may contain a plasticizer for better on-press developability.

Suitable examples of the plasticizer include: phthalate esters such as dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate and diallyl phthalate; glycol esters such as dimethyl glycol phthalate, ethyl phthalyl ethyl glycolate, methyl phthalyl ethyl glycolate, butyl phthalyl butyl glycolate and triethylene glycol dicaprylate; phosphate esters such as tricresyl phosphate and triphenyl phosphate; aliphatic dibasic acid esters such as diisobutyl adipate, dioctyl adipate, dimethyl sebacate, dibutyl sebacate, dioctyl azelate, and dibutyl maleate; polyglycidyl methacrylate, triethyl citrate, glycerin triacetyl ester, butyl laurate, etc.

The plasticizers are preferably added in amounts no more than about 30 wt% of the total solids in the image recording layer.

<Inorganic fine particles>

The image recording layer of the invention may contain inorganic fine particles in order to increase the strength of the hardened layer in the image areas and to improve the on-press developability of the nonimage areas.

Preferred examples of the inorganic fine particles are those of silica, alumina, magnesium oxide, titanium oxide, magnesium carbonate, calcium alginate, and mixtures thereof. These compounds may not be capable of converting light to heat and yet they can be used to reinforce the image recording layer, to enhance the interfacial adhesion through surface graining, or for other purposes.

The average size of the inorganic fine particles is preferably between 5 nm and 10 μm, more preferably between 0.5 and 3 μm. Within these ranges, the inorganic fine particles will be stably dispersed in the image recording layer to ensure that its strength is adequately retained and that the nonimage areas formed are hydrophilic enough to reduce the chance of scumming during printing.

The inorganic fine particles described above are readily available as commercial products, e.g. colloidal silica dispersions.

The content of the inorganic fine particles is preferably up to 20 wt%, more preferably up to 10 wt%, of the total solids in the image recording layer.

<Low-molecular weight hydrophilic compound>

The image recording layer of the invention may contain a hydrophilic low-molecular weight compound for better on-press developability.

The hydrophilic low-molecular weight compound may be exemplified by water-soluble organic compounds including, for example, glycols such as ethylene glycol, diethylene glycol, triethylene glycol, propylene glycol, dipropylene glycol, and tripropylene glycol, as well as ether or ester derivatives of such glycols; polyhydroxy compounds such as glycerin and pentaerythritol; organic amines such as triethanolamine, diethanolamine and monoethanolamine, as well as salts thereof; organic sulfonic acids such as toluenesulfonic acid and benzenesulfonic acid, as well as salts thereof; organic phosphonic acids such as phenylphosphonic acid, as well as salts thereof; organic carboxylic acids such as tartaric acid, oxalic acid, citric acid, malic acid, lactic acid, gluconic acid, and amino acids, as well as salts thereof.

<Forming the image recording layer>

In the present invention, several modes can be adopted to implement the method of incorporating the above-mentioned ingredients in the image recording layer. One is a molecule-dispersed image recording layer which is formed by applying a solution of the ingredients in a suitable solvent, as described in JP 2002-287334 A. Another mode is a microencapsulated image recording layer which contains all or part of the ingredients as being confined in microcapsules, as described in JP 2001-277740 A and JP 2001-277742 A. In such a mode, part of the ingredients may be contained without encapsulation. In a preferred embodiment of this case, hydrophobic ingredients may be incorporated in the microcapsules with hydrophilic ingredients being contained outside the microcapsules. The microencapsulated image recording layer is preferred for the purpose of providing better on-press developability.

The above-mentioned ingredients for the image recording layer can be microencapsulated by known methods. Exemplary methods for producing microcapsules include, but are not limited to, the following: a method which makes use of coacervation as described in US 2,800,457 B and US 2,800,458 B; a method which depends on interfacial polymerization as described in US 3,287,154 B, JP 38-19574 B and JP 42-446 B; a method which depends on polymer precipitation as described in US 3,418,250 B and US 3,660,304 B; a method which uses isocyanate polyol wall materials

as described in US 3,796,669 B; a method which uses isocyanate wall materials as described in US 3,914,511 B; a method which uses urea-formaldehyde or urea-formaldehyde-resorcinol wall forming materials as described in US 4,001,140 B, US 4,087,376 B and US 4,089,802 B; a method which uses melamine-formaldehyde resins, hydroxycellulose and other wall materials as described in US 4,025,445 B; in-situ monomer polymerization as described in JP 36-9163 B and JP 51-9079 B; a spray drying method as described in GB 930,422 B and US 3,111,407 B; and an electrolytic dispersing and cooling method as described in GB 952,807 B and GB 967,074 B.

The microcapsule walls preferred for use in the present invention have a three-dimensional crosslinking network and will swell in a solvent. From this viewpoint, the preferred materials for microcapsule walls are polyurea, polyurethane, polyesters, polycarbonates, polyamides, and mixtures thereof, with polyurea and polyurethane being particularly preferred. If desired, compounds having crosslinking functional groups such as ethylenically unsaturated bonds that can be introduced into the aforementioned binder polymers may be introduced into the microcapsule walls.

The average size of the microcapsules is preferably 0.01 to 3.0 μm, more preferably 0.05 to 2.0 μm, and most preferably 0.10 to 1.0 μm. Within these ranges, high image resolution and good storage stability are obtained.

To form the image recording layer of the present invention, the necessary ingredients described above are dispersed or dissolved in a solvent to prepare a coating solution, which is then applied. Solvents that can be used include, but are not limited to, ethylene dichloride, cyclohexanone, methyl ethyl ketone, methanol, ethanol, propanol, ethylene glycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulfolane, γ-butyl lactone, toluene, and water. These solvents are used either alone or in admixture. The concentration of the solids in the coating solution is preferably between 1 and 50 wt%.

In another practical method for forming the image recording layer of the invention, the same or different ingredients are dispersed or dissolved in the same or different solvents to prepare a plurality of coating solutions, which are applied and dried a multiple of times.

The amount (solids content) of the image recording layer deposited to the support after application and drying varies with use but in general it is preferably between 0.3 and 3.0 $g/m^2$. Within this range, the image recording layer will have satisfactory sensitivity and film characteristics.

Various application methods may be employed, as exemplified by bar coating, whirl coating, spray coating, curtain coating, dip coating, air knife coating, blade coating, roll coating, etc.

<Support>

The support that can be used in the presensitized plate of the present invention is not limited to any particular types and all plates that are dimensionally stable will do. Examples include paper, either laminated or not laminated with plastics (e.g. polyethylene, polypropylene and polystyrene), metal plates (e.g. aluminum, zinc and copper), plastic films [e.g. cellulose diacetate, cellulose triacetate, cellulose propionate, cellulose butyrate, cellulose acetate butyrate, cellulose nitrate, poly(ethylene terephthalate), polyethylene, polystyrene, polypropylene, polycarbonate and poly(vinyl acetal)], and paper or plastic films laminated or vapor deposited with the above-mentioned metals. Preferred supports include the polyester film and the aluminum plate. The aluminum plate is particularly preferred since it has high dimensional stability and is relatively inexpensive.

The aluminum plate may be a pure aluminum plate, an aluminum-based plate alloyed with very small amounts of dissimilar elements, or a thin film of pure aluminum or alloyed aluminum that is laminated with plastics. Dissimilar elements that may be contained in the aluminum alloy include silicon, iron, manganese, copper, magnesium, chromium, zinc, bismuth, nickel, titanium, etc. The content of dissimilar metals in the alloy is preferably no more than 10 wt%. In the present invention, the pure aluminum plate is preferred. However, a completely pure aluminum is difficult to produce by the current smelting technology and dissimilar elements may be contained in very small amounts. The composition of the aluminum plate is by no means specified and may appropriately be prepared from known and commonly used materials.

The thickness of the support is preferably 0.1 to 0.6 mm, more preferably 0.15 to 0.4 mm, and most preferably 0.2 to 0.3 mm.

Prior to use, the aluminum plate is preferably subjected to a surface treatment such as graining and anodizing. By these surface treatments, the aluminum plate is made more hydrophilic and given ease in assuring better adhesion between the image recording layer and the support. Before graining, the aluminum plate may optionally be degreased with a surfactant, an organic solvent, an aqueous alkaline solution, etc. in order to remove the rolling oil from the surface.

The surface of the aluminum plate may be grained by various methods such as mechanical graining, electrochemical graining (roughening by electrochemical dissolving of the surface), and chemical graining (roughening by selective chemical dissolving of the surface).

Mechanical graining can be done by known methods such as ball grinding, brush grinding, blast grinding, buff grinding, etc.

Electrochemical graining can be done with an alternating or direct current being applied through a liquid electrolyte containing an acid such as hydrochloric acid or sulfuric acid. Another method is by using mixed acids as described in JP 54-63902 A.

The grained aluminum plate may optionally be alkali etched using an aqueous solution of potassium hydroxide, sodium hydroxide, etc. and neutralized; thereafter, if desired, the plate may be anodized for enhanced abrasion resistance.

For anodizing the aluminum plate, one may use various electrolytes that can form porous oxide films. In general, sulfuric acid, hydrochloric acid, oxalic acid, chromic acid or mixtures thereof may be used. The concentration of these electrolytes can appropriately be determined depending on their type.

There is no generalizing of the anodizing conditions since they vary with the electrolyte used but typical conditions are as follows: a solution with an electrolyte concentration of 1-80 wt%; solution's temperature at 5-70 °C; current density at 5-60 A/$dm^2$; voltage at 1-100 V; electrolysis time ranging from 10 seconds to 5 minutes. The amount of the anodized film to be formed is preferably between 1.0 and 5.0 g/$m^2$, more preferably between 1.5 and 4.0 g/$m^2$. Within these ranges, a lithographic printing plate can be obtained that has satisfactory press life and high scratch resistance in the nonimage areas.

The substrate that has been subjected to the aforementioned surface treatments to have an anodic oxide film may directly be used as the support in the present invention. However, if it is necessary to make further improvement in adhesion to the upper layer, in hydrophilicity, anti-smudge property, heat insulation, etc., additional treatments may be applied as appropriate, including the enlargement of micropores in the anodic oxide film, the sealing of such micropores, and the hydrophilization of the film's surface by immersion in an aqueous solution containing hydrophilic compounds, as described in JP 2001-253181 A and JP 2001-322365 A.

Hydrophilization can be performed by an alkali metal silicate method as described in US 2,714,066 B, US 3,181,461 B, US 3,280,734 B and US 3,902,734 B. In this method, the support is immersed or electrolyzed in an aqueous solution of sodium silicate, etc. Other applicable methods include treatment with potassium fluorozirconate as described in JP 36-22063 B, and treatment with poly(vinylphosphonic acid) as described in US 3,276,868 B, US 4,153,461 B and US 4,689,272 B.

In the case of using a support such as a polyester film that is not adequately hydrophilic on the surface, a hydrophilic layer is desirably applied to render its surface hydrophilic. Preferred hydrophilic layers include the following: a hydrophilic layer of the type described in JP 2001-199175 A which is prepared by applying a coating solution containing a colloid of an oxide or hydroxide of at least one element selected from among beryllium, magnesium, aluminum, silicon, titanium, boron, germanium, tin, zirconium, iron, vanadium, antimony and a transition metal; a hydrophilic layer having an organic hydrophilic matrix obtained by crosslinking or pseudo-crosslinking of an organic hydrophilic polymer, and a hydrophilic layer having an inorganic hydrophilic matrix obtained by sol-gel conversion comprising hydrolysis and condensation reaction of polyalkoxysilanes, titanate, zirconate or aluminate, as described in JP 2002-79772 A; and a hydrophilic layer comprising an inorganic thin film having a metal oxide containing surface. Particularly preferred among these is a hydrophilic layer formed by applying a colloid of a silicon oxide or hydroxide.

In the case of using a polyester film and the like as the support in the present invention, an antistatic layer is preferably provided either on the side of the support where the hydrophilic layer is formed or on the opposite side or on both sides. If an antistatic layer is provided between the support and the hydrophilic layer, it also contributes to enhancing the adhesion to the hydrophilic layer. An example of the antistatic layer that can be used is described in JP 2002-79772 A and it is a polymer layer that has fine metal oxide particles and a matting agent dispersed therein.

The support preferably has a center-line-average roughness between 0.10 and 1.2 µm. Within this range, good adhesion to the image recording layer, long press life and adequate smudge resistance can be obtained.

The color density of the support is preferably between 0.15 and 0.65 in terms of reflection density. Within this range, halation can be effectively prevented during imagewise exposure to ensure satisfactory image formation and reliable layout or position proofing after development.

<Undercoating layer>

In the presensitized plate of the present invention, the support is preferably overlaid with an undercoating layer of a compound containing a polymerizable group. If an undercoating layer is provided, the image recording layer is superposed on it. The undercoating layer in the exposed areas reinforces the adhesion between the support and the image recording layer and, in the unexposed areas, it allows for easy stripping of the image recording layer from the support, thus realizing improved on-press developability.

The undercoating layer may suitably be formed of the silane coupling agent described in JP 10-282679 A which has addition polymerizable, ethylenic double bond containing reactive groups, or the phosphorus compound described in JP 2-304441 A which has ethylenically unsaturated bond containing reactive groups.

The amount (solids content) of the undercoating layer deposited is preferably between 0.1 and 100 mg/$m^2$,

more preferably between 1 and 30 $mg/m^2$.

<Back coating layer>

After the support is subjected to any necessary surface treatment or after the undercoating layer is formed on it, a back coat may be provided on the reverse side of the support as required.

Suitable examples of the back coat include a coating layer of the organic high-molecular weight compound described in JP 5-45885 A, and a coating layer comprising metal oxides which are obtained by hydrolyzing and polycondensing the organic or inorganic metal compounds described in JP 6-35174 A. Alkoxylated compounds of silicon such as $Si(OCH_3)_4$, $Si(OC_2H_5)_4$, $Si(OC_3H_7)_4$ and $Si(OC_4H_9)_4$ are particularly preferred for use since they can be made from inexpensive and, hence, readily available raw materials.

On the following pages, a plate exposing apparatus according to the second aspect of the present invention is described in detail with reference to the preferred embodiments shown in the accompanying drawings.

Figs. 1A and 1B are side views showing schematically the essential part of the plate exposing apparatus according to an embodiment of the second aspect of the present invention.

The plate exposing apparatus according to the embodiment under consideration which is generally indicated by 100 mainly comprises a housing 102 for accommodating a presensitized plate (hereunder referred to as a photosensitive material) as the original plate of the printing plate , an oxygen-free state creating section 104 for replacing the air in the housing 102 with an inert gas, and a photosensitive material exposing means 106 for irradiating the photosensitive material 122 with a specified amount of exposing light.

The housing 102 comprises a transparent retainer member 108 as a flat plate typically made of glass, a press member 110 that is made of a rigid material and which is driven to reciprocate (in the directions of arrow A) by a moving mechanism (not shown) to be urged against and separated (brought out of engagement) from the transparent retainer member 108, and a wall member 112 that surrounds the peripheries of both members 108 and 110 and two sides of which pivot (in the directions of arrow B) to close and open the housing 102. The other two sides of the wall member 112 (which are parallel to the drawing plane) are permanently fixed.

Fig. 1A shows the state where the wall member 112 has pivoted upward to separate from each of the transparent retainer member 108 and the press member 110 so that the photosensitive material 122 can be loaded into or unloaded from the housing 102; Fig. 1B shows the state where the wall member 112 has pivoted downward to come into contact with each of the transparent retainer member 108 and the press member 110, so the photosensitive material 122 can be exposed to light (in the housing 102 that has been closed).

The oxygen-free state creating section 104 comprises a container 114 of an inert gas such as nitrogen (or its generator but the term "container" is hereunder used for simplicity), an oxygen blocking time control means 116 for controlling the action of the inert gas container 114, a gas ejecting nozzle 118 through which the inert gas being supplied from its container 114 is introduced into the housing 102, and an exhaust nozzle 120 through which the gas is discharged out of the housing 102 after the end of exposure.

Speaking of the gas ejecting nozzle 118 through which to introduce the inert gas into the housing 102, special consideration is preferably made in order to ensure rapid replacement of the air in the housing 102 with the inert gas and an example is by arranging a plurality of such nozzles across the width of the photosensitive material (in the direction perpendicular to the drawing plane). Speaking of the exhaust nozzle 120, it preferably has the minimum required cross-sectional area in order to prevent the loss of the inert gas to the outside of the housing 102 after it has replaced the air.

The photosensitive material exposing means 106 is an exposing apparatus of a common, known scanning beam type which ensures that the photosensitive material 122 is irradiated at the photosensitive layer 124 (the top surface of the photosensitive material 122 as seen in Figs. 1A and 1B) with a specified amount of exposing light. In the case shown, the photosensitive layer 124 of the photosensitive material 122 as a flat plate is scanned two-dimensionally and exposed to a laser beam modulated in accordance with the data on the image to be recorded; it should, however, be noted that this is not the sole case of the present invention.

The plate exposing apparatus 100 according to the embodiment under consideration is operated in the following manner. First, the press member 110 is separated from the transparent retainer member 108 and the wall member 112 is pivoted to the OPEN position; then, the photosensitive material 122 to be exposed is loaded into the housing 102, the press member 110 is urged toward the transparent retainer member 108 and the wall member 112 is pivoted to the CLOSE position so that gaskets 112a seal the interior of the housing 102. Thereafter, according to a preset pattern of inert gas supply (for details, see below) and under control of the oxygen blocking time control means 116, an inert gas is supplied from the container 114 to replace the air in the housing 102.

When purging with the inert gas ends after the lapse of a specified period of time, the photosensitive material 122 in the housing 102 is subjected to specified scan beam exposure by the exposing means 106. In the embodiment under consideration, supply of the inert gas from the container 114 shall be continued during the exposure under control

of the oxygen blocking time control means 116. When a specified period of time lapses after the end of exposure, the supply of the inert gas is discontinued, also under control of the oxygen blocking time control means 116, and thereafter the press member 110 is separated from the transparent retaining member 108 and the wall member 112 is pivoted to the OPEN position so that the interior of the housing 102 is reverted to normal air atmosphere.

Thus described above are the layout of the essential parts of the plate exposing apparatus 100 according to one embodiment of the present invention, as well as an outline of its operation.

On the following pages, the method for making a lithographic printing plate according to the first aspect of the present invention using the exposing apparatus 100 is described with reference to a specific example.

Fig. 2 is a flow sheet showing the sequence of major steps in the method for making lithographic printing plates using the exposing apparatus 100 according to the described embodiment of the present invention. As Fig. 2 shows, the method of interest for making a lithographic printing plate starts with separating the press member 110 from the transparent retainer member 108, pivoting the wall member 112 to the OPEN position, and loading the photosensitive material 122 to be exposed into the housing 102, with the photosensitive layer 124 facing up (step 202, in which the photosensitive material 122 is loaded in the direction indicated by arrow C in Fig. 1).

In the next step, the press member 110 is urged toward the transparent retainer member 108, the wall member 112 is pivoted to the CLOSE position, replacement of the air in the housing 102 by an inert gas is started (step 204, in which the inert gas is supplied in the direction indicated by arrow D in Fig. 1). Every action in this step is performed under control of the oxygen blocking time control means 116.

To be more specific, the oxygen blocking time control means 116 has preset data for the oxygen blocking time both before and after the exposing of the photosensitive material 122 and on the basis of that data, replacement of the air in the housing 102 by an inert gas gets started.

When a preset specified period of time has passed since the start of replacement of the air in the housing 102 by an inert gas, it is considered that purging with the inert gas has substantially ended and the photosensitive material 122 (or, actually, the photosensitive layer 124) is subjected to specified scan beam exposure by the exposing means 106 (step 206). Needless to say, the exposure to be performed in step 206 is so-called "imagewise exposure" which is based on the image data for making lithographic printing plates.

After the exposure in step 206 ends, the inert gas supply from the container 114 is further continued on the basis of the data preliminarily set in the oxygen blocking time control means 116 for the oxygen blocking time that should continue after the end of exposure; at the point in time when the specified oxygen blocking time has passed (step 208), the inert gas supply from the container 114 is discontinued while at the same time the wall member 112 is pivoted to the OPEN position so that the interior of the housing 102 is opened to the atmosphere (step 210).

With the interior of the housing 102 being thus opened to the atmosphere, the exposed photosensitive material 122 in the housing 102 is now in such a state that it permits the presence of oxygen in the photosensitive layer 124; it is substantially no longer photosensitive and can be handled in a lighted room. Hence, to perform on-press development, the operator sets the exposed material 122 on a specified printing press (step 212).

In step 212, on-press development may be performed in the following manner; as is conventionally done, the material 122 that has been set on the printing press is supplied with ink and fountain solution simultaneously and the press is operated in the same way as in the ordinary printing process, whereby so-called "on-press development" is effected and at that point in time the making of a lithographic printing plate ends.

According to the platemaking method that has been described above with reference to the example, even a presensitized plate that has no oxygen barrier layer, on which a latent image is formed by photopolymerization and which is to be processed by development on a printing press may be employed to make lithographic printing plates by a process all steps of which can be performed in a lighted room.

And, the plate exposing apparatus 100 described with reference to the foregoing embodiment can suitably be employed to implement the method.

The following is a modified version of the above-described method for making lithographic printing plates.

In the platemaking method described with reference to the above example, the action for interrupting oxygen is commenced at a point in time that precedes the start of exposure of the photosensitive material 122 by the duration of time required for the replacement of the air in the housing 102 with an inert gas to be substantially completed and even after the end of exposure, the replacement with the inert gas is continued for the period of time substantially equal to the time required for oxygen to permeate into the photosensitive layer 124 of the photosensitive materials 122. However, oxygen needs only to be purged from the photosensitive material 122 during exposure of the photosensitive material, or the time during which there exist radicals generated in the photosensitive material for photopolymerization.

Therefore, the action for interrupting oxygen before the start of exposure or the action for interrupting oxygen after the end of exposure can each be omitted either partly or entirely. Needless to say, whether the action for such oxygen interruption should be omitted or not is preferably determined on the basis of the results of reviewing by detailed experimentation and other studies.

Further, in the above-described platemaking method, the action for interrupting oxygen is realized by replacing

the air in the housing 102 with an inert gas. Of course, the same result can be obtained by removing substantially all of the air in the housing 102 (which actually is oxygen).

If desired, the action for interrupting oxygen may be performed in two steps, the first step by removing substantially all of the air in the housing 102 and the second step by introducing an inert gas after the air has been removed.

On the following pages, there are described several other embodiments of plate exposing apparatus that can be employed in place of the plate exposing apparatus 100.

Each of those alternatives is simple to handle, does not incur an increased running cost and, hence, provides a plate exposing apparatus that can be suitably applied in the direct platemaking process contemplated in the present invention.

Fig. 3 is a side view showing schematically the essential parts of a plate exposing apparatus according to another embodiment of the second aspect of the present invention which is generally indicated by 300. The plate exposing apparatus 300 according to the embodiment under consideration may well be regarded as an improvement of the plate exposing apparatus 100 shown in Fig. 1. The difference is that the press member 310 of the housing 302 comprises a rigid base furnished with a cushion layer 310a made of a flexible material such as rubber or gel.

Having the cushion layer 310a in the press member 310, the plate exposing apparatus 300 according to the embodiment under consideration has the advantage that the volume of the gap that forms around the photosensitive material 322 when it is depressed by the press member 310 is sufficiently reduced to ensure that air can be removed or replaced with an inert gas more positively.

In Fig. 3, the components which are the same as those of the plate exposing apparatus 100 shown in Fig. 1 are identified by the same reference numerals plus 200 and will not be described in detail.

Figs. 4A and 4B are side views showing schematically the essential parts of a plate exposing apparatus according to still another embodiment of the second aspect of the present invention which is generally indicated by 400. The plate exposing apparatus 400 according to the embodiment under consideration may well be regarded as a variant of the plate exposing apparatus 100 shown in Fig. 1. The difference is that the air in the housing 402 is not replaced with an inert gas but that substantially all of it is removed from the housing 402.

In the plate exposing apparatus 100 shown in Fig. 1, the oxygen-free state creating section 104 which essentially comprises the inert gas container 114 and the oxygen blocking time control means 116 which controls its action is used to replace the air in the housing 102 with an inert gas. In the plate exposing apparatus 400 according to the embodiment under consideration, the inert gas ejecting nozzle 418 is used as the port of evacuation effected by a vacuum pump 426.

Thanks to this design, the plate exposing apparatus 400 according to the embodiment under consideration offers the advantage of enabling the formation of an oxygen-free atmosphere at relatively low cost by simply removing the air in the housing 402 rather than by replacing it with an inert gas.

In Figs. 4A and 4B, the components which are the same as those of the plate exposing apparatus 100 shown in Fig. 1 are identified by the same reference numerals plus 300 and will not be described in detail.

Fig. 5 is a side view showing schematically a variant of the plate exposing apparatus 400 according to the embodiment shown in Fig.4. The plate exposing apparatus according to the embodiment under consideration is generally indicated by 500 and characterized in that a press member 510 furnished with rollers 510a made of an elastic material such as rubber is used in place of the press member 410 of the plate exposing apparatus 400 shown in Fig. 4.

By virtue of this design, the plate exposing apparatus 500 according to the embodiment under consideration not only allows the photosensitive material 522 to be loaded into and unloaded from the housing 502 more smoothly but it also has the advantage that the press member 510 needs to be separated by a smaller distance from the photosensitive material 522 when it is loaded into or unloaded from the housing 502; this contributes to shortening the time required to change photosensitive materials.

In Fig. 5, the components which are the same as those of the plate exposing apparatus 400 shown in Fig. 4 are identified by the same reference numerals plus 100 and will not be described in detail.

The foregoing examples relate to the plate exposing apparatus of a so-called "flat bed type" which sets the photosensitive material on a flat plate. On the pages that follow, examples of the so-called "drum type" exposing apparatus having a drum-shaped retainer for photosensitive material are described. As is well known, plate exposing apparatuses of the drum type comprise an inner drum type (exposing light is applied to the inner surface of the drum) and an outer drum type (exposing light is applied to the outer surface of the drum) and the following description covers both versions.

Figs. 6A, 6B, 6C and 6D show a plate exposing apparatus of the inner drum type by means of sections of the drum-shaped retainer for photosensitive material that are cut through a plane crossing its center axis at right angles. The drum is yet to be loaded with the photosensitive material (Fig. 6A), it is being loaded with the photosensitive material (Fig. 6B), it is being prepared for evacuation after loading the photosensitive material (Fig. 6C), and it is in the process of evacuation (Fig. 6D).

The plate exposing apparatus according to the embodiment under consideration is generally indicated by 600

and comprises the following main components: a transparent retainer member 608 made of a glass cylinder part of which is taken away; a mechanism provided outside the transparent retainer member 608 for feeding and taking up a flexible press member 610; an exhaust mechanism (vacuum pump 626) for removing air out of a closed space (for details, see below) that is formed between the two members 608 and 610; and a laser beam scan exposing means 606 which is provided inside the transparent retainer member 608 and which uses a rotating mirror (spinner mirror).

The mechanism for feeding and taking up the press member 610 is so adapted that it can feed or take up the press member 610 at a desired position between its leading and trailing edges; it is also adapted to be capable of driving the press member 610 not only in the same direction but also in opposite directions. Because of this design, the mechanism for feeding and taking up the press member 610 first receives the photosensitive material 622 to be loaded, then transports it to a predetermined position, where it cooperates with the exhaust mechanism to retain the photosensitive material 622 within the closed space that it forms with the transparent retainer member 608.

In the plate exposing apparatus 600 according to the embodiment under consideration, the photosensitive material 622 that has been supplied, with the photosensitive layer 624 facing the transparent retainer member 608 (i. e., facing inward), is first received by driving the press member feed/take-up mechanism in a clockwise direction (Fig. 6A) and then transported, as indicated by arrows E and F, to a specified position suitable for exposure by the scan exposing means 606 (Figs. 6B, 6C and 6D), where the interior of the space (closed space) formed between the photosensitive material 622 and its transparent retainer 608 is subjected to vacuum drawdown by the press member feed/take-up mechanism in cooperation with the exhaust mechanism.

After substantially all of the air that surrounds the photosensitive material 622 loaded to a specified position has been thus removed, the scan exposing means 606 is actuated to perform common laser beam scan exposure on the photosensitive material 622. The aforementioned vacuum drawdown of the closed space (i.e., to keep its interior in an oxygen-free state) is preferably continued until exposure ends, more preferably until the passage of a specified period of time after the end of exposure.

A benefit this design offers to the plate exposing apparatus 600 according to the embodiment under consideration is that even if it employs the drum-shaped transparent retainer member 608, substantially all of the air in the housing 602 can be removed, ensuring that the photosensitive material 622 loaded into the housing 602 can be exposed more positively and easily in the oxygen-free environment.

In Figs. 6A, 6B, 6C and 6D, the components which are the same as those of the plate exposing apparatus 100 shown in Fig. 1 are identified by the same reference numerals plus 500 and will not be described in detail.

Figs. 7A and 7B show an example of a plate exposing apparatus of the outer drum type; Fig. 7A illustrates in perspective a section of the drum-shaped photosensitive material retainer that is cut through a plane crossing its center axis at right angles; and Fig. 7B is a section of the retainer that is cut through a plane passing through its center axis. Fig. 7A is also a perspective view showing schematically the photosensitive material as it is being loaded into the housing, and Fig. 7B illustrates the photosensitive material as it is subjected to evacuation after loading.

The plate exposing apparatus according to the embodiment under consideration is generally indicated by 700 and comprises the following main components: a transparent retainer member 708 made of a glass cylinder; a cylindrical flexible press member 710 provided inside the transparent retainer member 608; an exhaust mechanism (having a vacuum pump not shown) for removing air out of a closed space (for details, see below) that is formed between the two members 708 and 710; and a laser beam scan exposing means 706 which is provided outside the transparent retainer member 608.

The two ends of the transparent retainer member 708 are closed with caps of closing members 728a and 728b. One of those closing members, say, member 728b, has a vent opening 732a through which to remove air from within a gap 730 in the form of a thin-walled cylinder that is formed between the transparent retainer member 708 and the press member 710; the vent opening 732a is connected to the vacuum pump referred to above. The closing member 728b also has a communication hole 732b for maintaining the pressure in the press member 710 atmospheric.

Designed this way, the plate exposing apparatus 700 according to the embodiment under consideration operates as follows: the photosensitive material 722 is loaded into the gap 730 (in the direction of arrows G) and the vacuum pump is actuated to remove air out of the gap 730 via the vent opening 732a, whereupon the press member 710, under the atmospheric pressure being exerted on its inner surfaces via the communication hole 732b, depresses the photosensitive material 722 toward the transparent retainer member 708 so that it is positively retained in position while at the same time the vacuum around it is also maintained positively.

When substantially all of the air that surrounds the photosensitive material 722 has been thus removed, the scan exposing means 706 is actuated to perform laser beam scan exposure on the photosensitive material 722. The aforementioned vacuum drawdown of the closed space (i.e., the gap 730) (to create an oxygen-free state) is preferably continued until exposure ends, more preferably until the passage of a specified period of time after the end of exposure.

A benefit this design offers to the plate exposing apparatus 700 according to the embodiment under consideration is that even if it employs the drum-shaped transparent retainer member 708, substantially all of the air in the housing 702 can be removed, ensuring that the photosensitive material 722 loaded into the housing 702 can be exposed

more positively and easily in the oxygen-free environment.

Note that the evacuation mechanism in the printing plate exposing apparatuses 600 and 700 described above with reference to Figs. 6 and 7 may be replaced by a mechanism for replacing the air in the housing 702 with an inert gas. Needless to say, this alternative design is essentially identical in other respects and can yet create an oxygen-free environment in a more positive way.

As described on the foregoing pages, the present invention has solved the various problems with the prior art and offers a method for making a printing plate such as a lithographic printing plate from an original or virgin plate of the printing plate such as a presensitized plate by a process all steps of which can be performed in a lighted room. More specifically, the original plate such as the presensitized plate and the printing plate such as the lithographic printing plate can be handled in every step of the process in a lighted room under illumination with ordinary light.

The present invention also offers a plate exposing apparatus that can suitably be used to implement the platemaking method that offers the various benefits described above. As a result, the operator finds himself capable of performing the above-described, safe and efficient platemaking process in a positive and easy manner.

More specifically, even a presensitized plate that has no oxygen barrier layer and which is to be processed by on-press development after forming a latent image by photopolymerization can advantageously be subjected to the direct platemaking process which is simple to operate and does not incur an increased running cost.

The foregoing embodiments are merely intended to be exemplary of the present invention and it goes without saying that the present invention is by no means limited to those embodiments and various modifications and improvements can be made without departing from the scope and spirit of the invention.

For instance, in each of the plate exposing apparatuses that depend on the methods of interrupting oxygen according to the foregoing embodiments, the transparent retainer member for supporting the photosensitive material may be replaced by an opaque member whereas the press member for depressing the photosensitive material against the support member may be composed of a scratch-resistant transparent sheet or the like and the air between the two members is removed to enable exposure in an oxygen-free environment.

## Claims

**1.** A method for making a printing plate , comprising:

substantially depriving of oxygen at least an exposed area of an original plate of a lithographic printing plate being exposed to light at least during exposure; and
exposing said original plate to said light at a wavelength of between 250 nm and 420 nm,

wherein said original plate of the lithographic printing plate has on a support an image recording layer containing a polymerization initiator, a polymerizable compound and a binder polymer, being sensitive to the light at the wavelengths of between 250 nm and 420 nm, having no oxygen barrier layer, and being removable with a printing ink and/or a fountain solution.

**2.** The method according to claim 1, wherein said exposed areas and their neighborhood are held substantially oxygen-free state after the exposure for a specified period of time.

**3.** The method according to claim 1 or 2, wherein said exposed areas and their neighborhood are held substantially oxygen-free state for a specified period of time both before and after the exposure.

**4.** The method according to any one of claims 1 to 3, wherein, after said exposed areas and their neighborhood are held substantially oxygen-free state for a specified period of time following the exposure, said original plate exposed to the light is exposed to atmospheric air to inhibit occurrence of photo-polymerization.

**5.** The method according to any one of claims 1 to 4, wherein said substantially oxygen-free state is maintained by replacement with an inert gas of air in a closed space formed by a transparent retainer member that retains said original plate on a first side where said image recording layer is provided and a press member that covers a second side of said support of said original plate and which can be moved to contact or depart from said transparent retainer member.

**6.** The method according to any one of claims 1 to 4, wherein said substantially oxygen-free state is maintained by displacing air in a closed space formed by a transparent retainer member that retains said original plate on a first side where said image recording layer is provided and a press member that covers a second side of said support

of said original plate and which can be moved to contact or depart from said transparent retainer member.

**7.** A plate exposing apparatus, comprising:

exposure means for exposing to light an original plate of a printing plate that does not have an oxygen barrier layer, on which latent image is formed by photo-polymerization and which is subjected to development on a printing press; and
oxygen blocking means for ensuring that exposure is performed such that at least an exposed area of said original plate being exposed to the light are substantially deprived of oxygen at least during the exposure.

**8.** The apparatus according to claim 7, further comprising:

oxygen blocking time control means for controlling a period of time for which oxygen is interrupted by said oxygen blocking means.

**9.** The apparatus according to claim 8, wherein said oxygen blocking time control means is capable of controlling oxygen interruption for any duration of time in the period between a first specified time before and a second specified time after the exposure of said original plate.

**10.** The apparatus according to any one of claims 7 to 9, wherein said oxygen blocking means comprises:

a transparent retainer member that retains said original plate on a first side where said image recording layer is provided;
a press member that covers a second side of said support of said original plate and which can be moved to contact or depart from said transparent retainer member; and
replacement means for replacing with an inert gas air in a closed space formed by said transparent retainer member and said press member.

**11.** The apparatus according to any one of claims 7 to 9, wherein said oxygen blocking means comprises:

a transparent retainer member that retains said original plate on a first side where said image recording layer is provided;
a press member that covers a second side of said support of said original plate and which can be moved to contact or depart from said transparent retainer member; and
displacement means for displacing air in a closed space formed by said transparent retainer member and said press member.

**12.** The apparatus according to any one of claims 7 to 11, wherein said plate exposing apparatus is a flat bed type exposing apparatus for scanning on a plane of a flat bed, an inner drum type exposing apparatus for scanning on an inner surface of a drum or an outer drum type exposing apparatus for scanning on an outer surface of a drum.

**13.** The apparatus according to any one of claims 10 to 12, wherein said transparent retainer member that retains said original plate on the first side where said image recording layer is provided and a press member that covers the second side of said support of said original plate and which can be moved to contact or depart from said transparent retainer member are combined and assembled for scanning on either a plane of a flat bed or an inner surface of a drum or an outer surface of a drum.

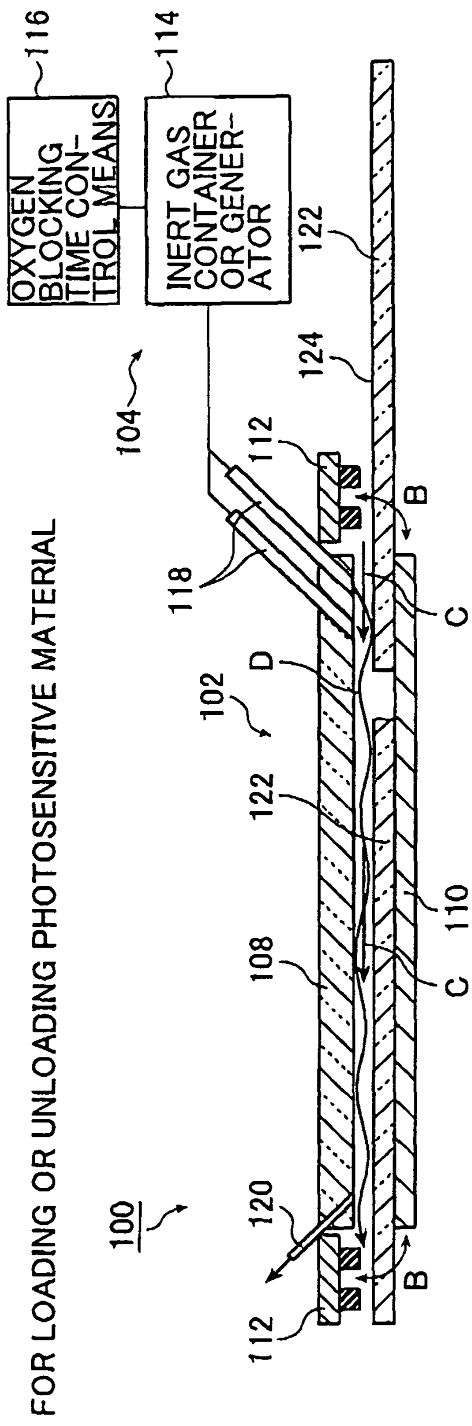
FOR LOADING OR UNLOADING PHOTOSENSITIVE MATERIAL
100
102
104
108
110
112
112
114
116
118
120
122
122
124
B
B
C
C
D
OXYGEN BLOCKING TIME CON-TROL MEANS
INERT GAS CONTAINER OR GENER-ATOR

FIG.1A

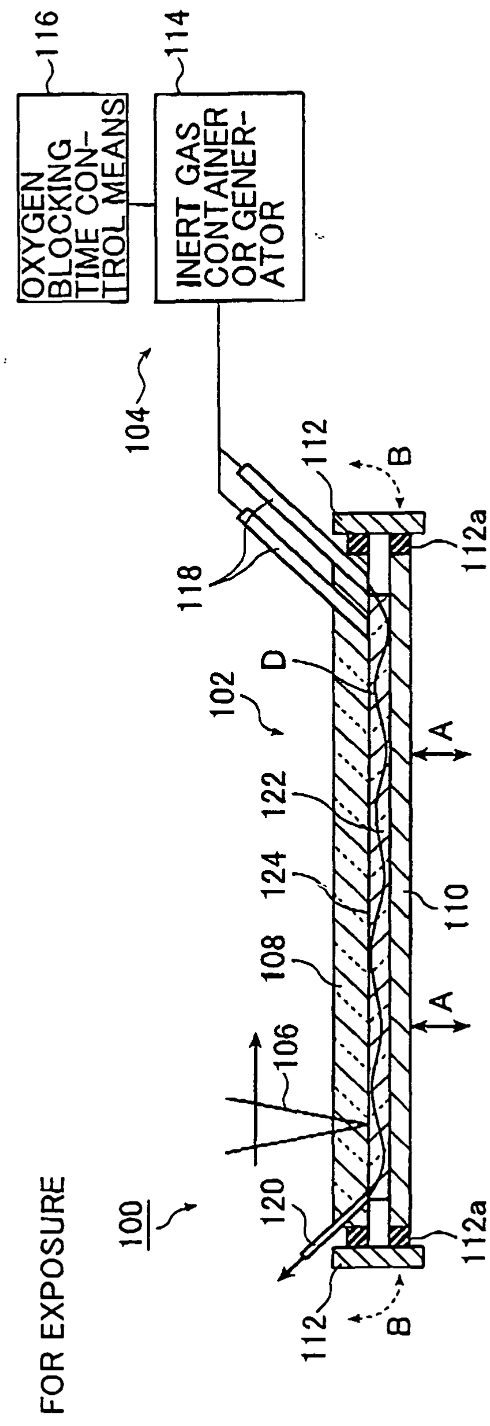
FOR EXPOSURE
100
102
104
106
108
110
112
112
112a
112a
114
116
118
120
122
124
A
A
B
B
D
OXYGEN BLOCKING TIME CON-TROL MEANS
INERT GAS CONTAINER OR GENER-ATOR

FIG.1B

FIG. 2

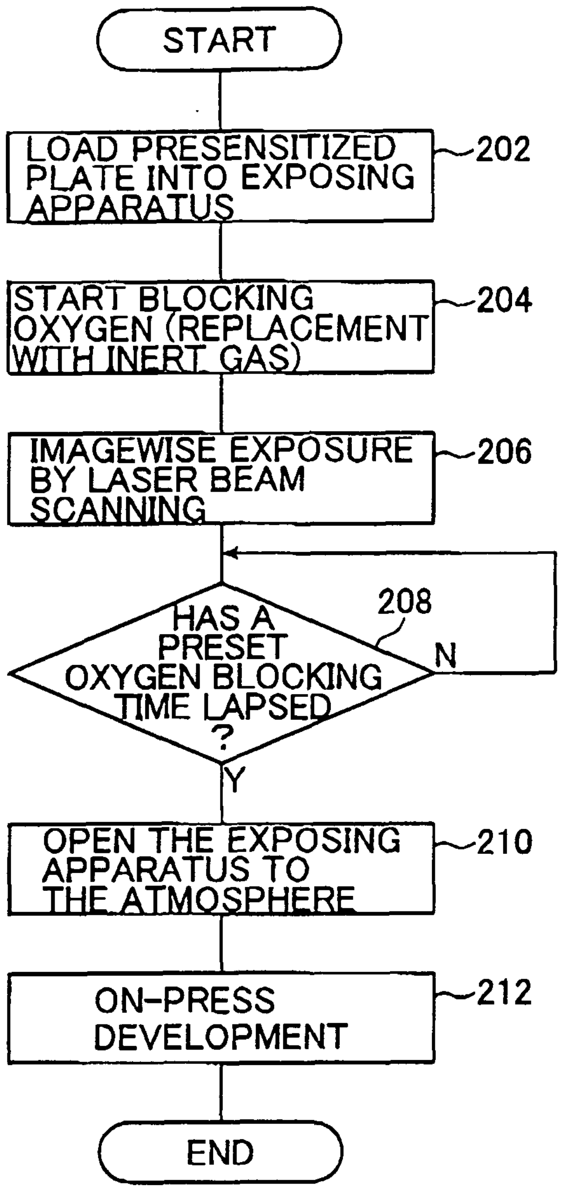
START
LOAD PRESENSITIZED PLATE INTO EXPOSING APPARATUS
202
START BLOCKING OXYGEN (REPLACEMENT WITH INERT GAS)
204
IMAGEWISE EXPOSURE BY LASER BEAM SCANNING
206
HAS A PRESET OXYGEN BLOCKING TIME LAPSED ?
208
N
Y
OPEN THE EXPOSING APPARATUS TO THE ATMOSPHERE
210
ON-PRESS DEVELOPMENT
212
END

FIG.3

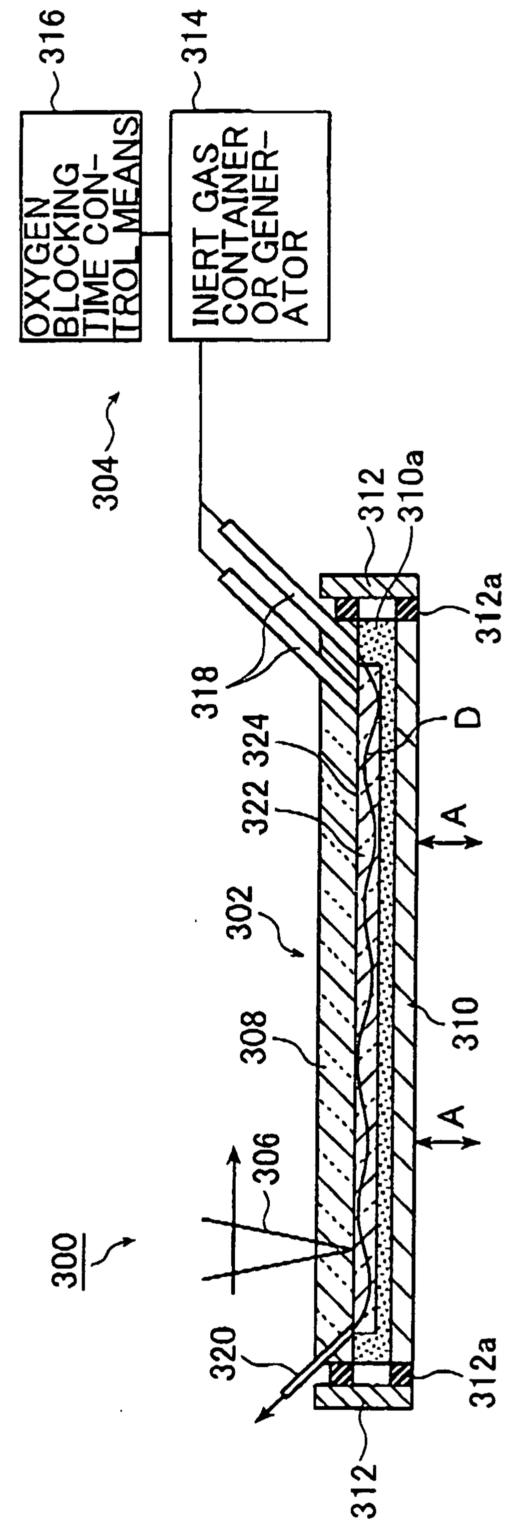

OXYGEN BLOCKING TIME CON-TROL MEANS
316
INERT GAS CONTAINER OR GENER-ATOR
314
304
300
302
306
308
310
310a
312
312a
318
320
322
324
A
A
D

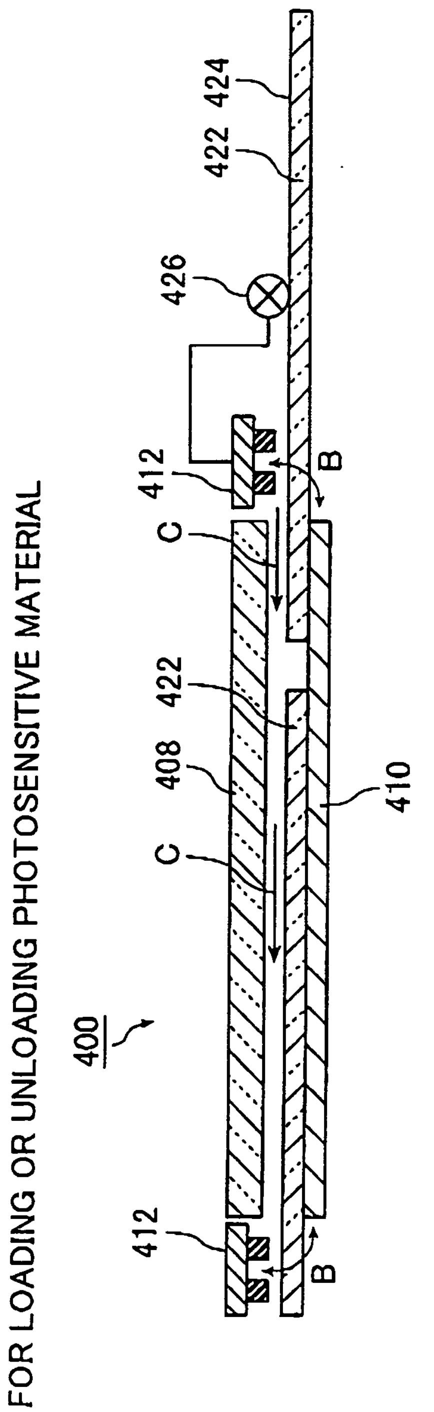
FOR LOADING OR UNLOADING PHOTOSENSITIVE MATERIAL
400
412
C
408
422
C
412
426
422
424
B
B
410

FIG. 4A

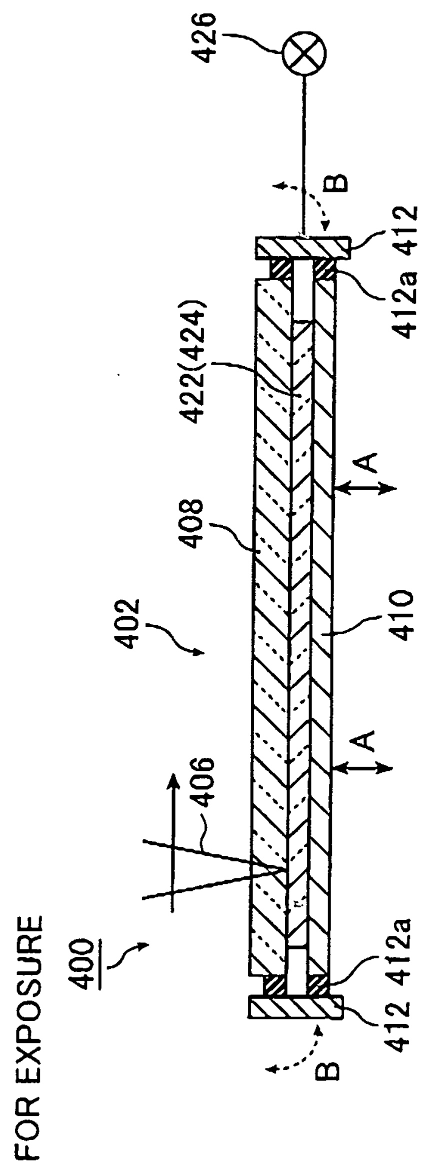
FOR EXPOSURE
400
406
402
408
422(424)
426
B
B
A
A
410
412 412a
412a 412

FIG. 4B

FIG. 5

FOR LOADING OR UNLOADING PHOTOSENSITIVE MATERIAL

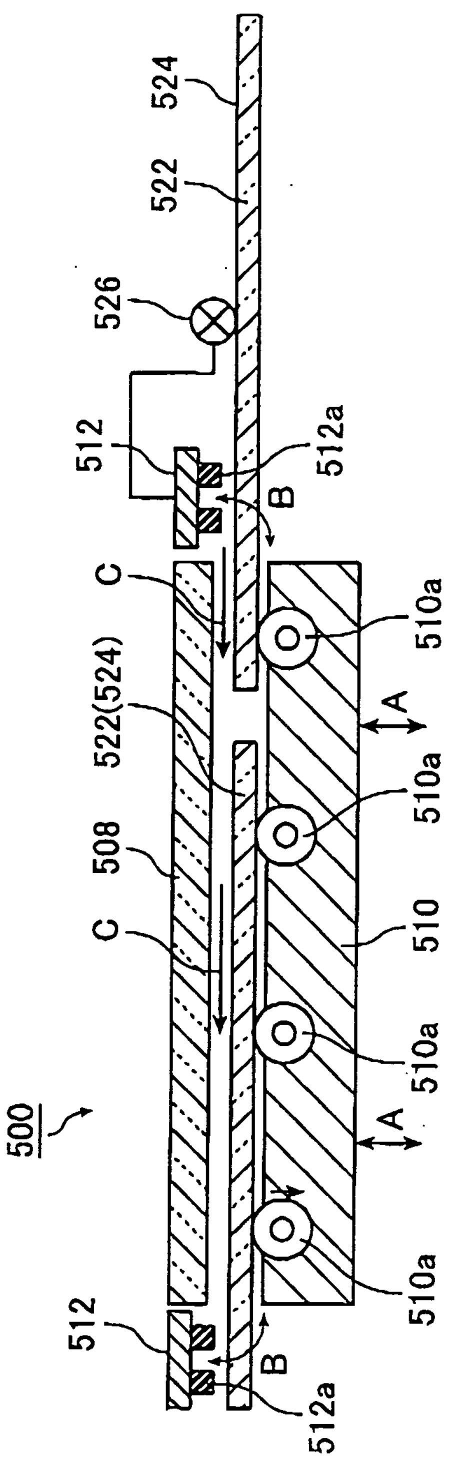

FIG.6A

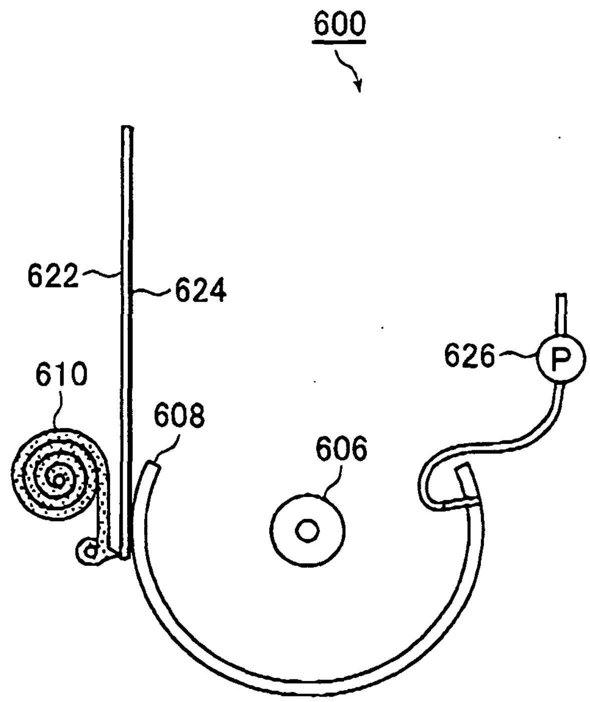


FIG.6B

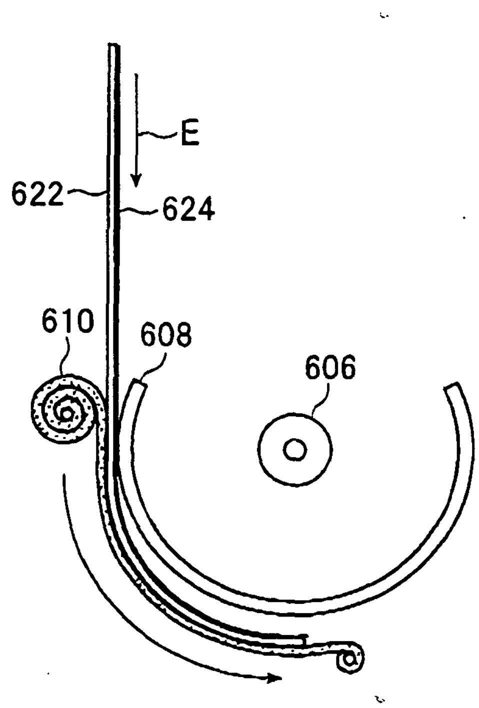


FIG.6C

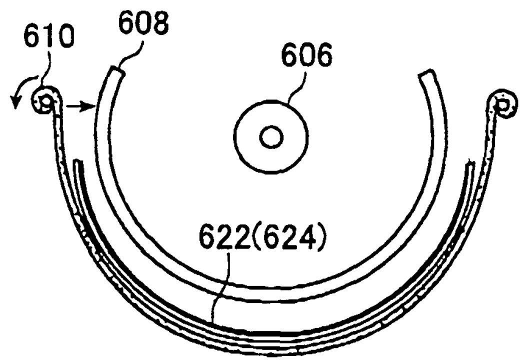


FIG.6D

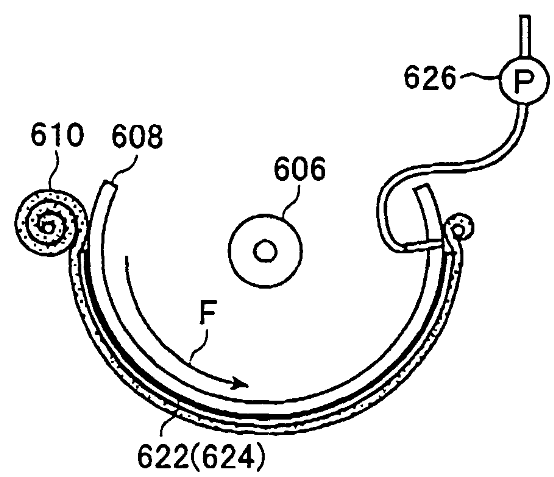

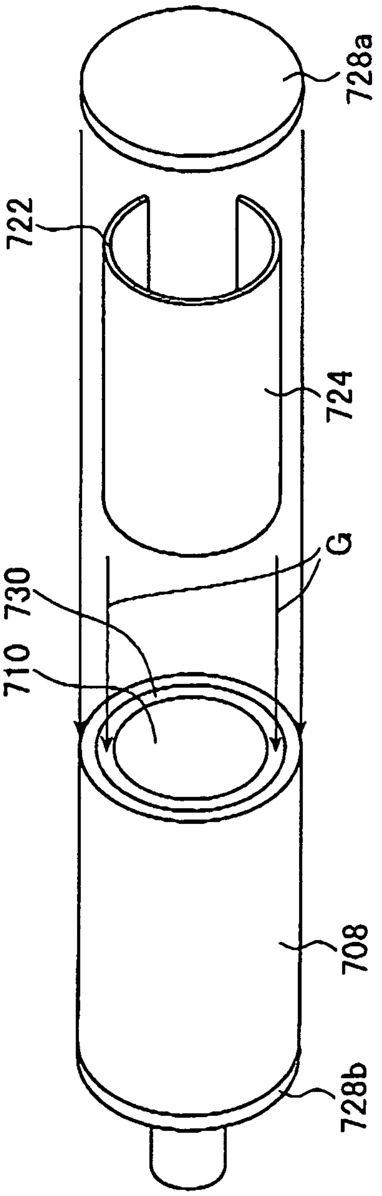
728a
722
724
G
710
730
708
728b

FIG. 7A

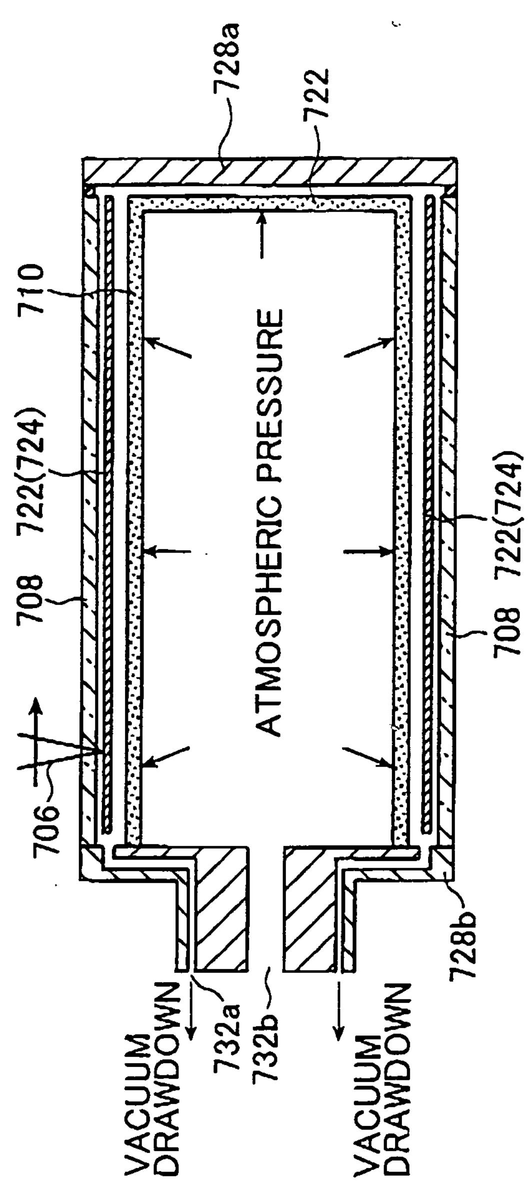
728a
722
710
722(724)
708
706
ATMOSPHERIC PRESSURE
722(724)
708
728b
VACUUM DRAWDOWN
732a
732b
VACUUM DRAWDOWN

FIG. 7B

FIG.8

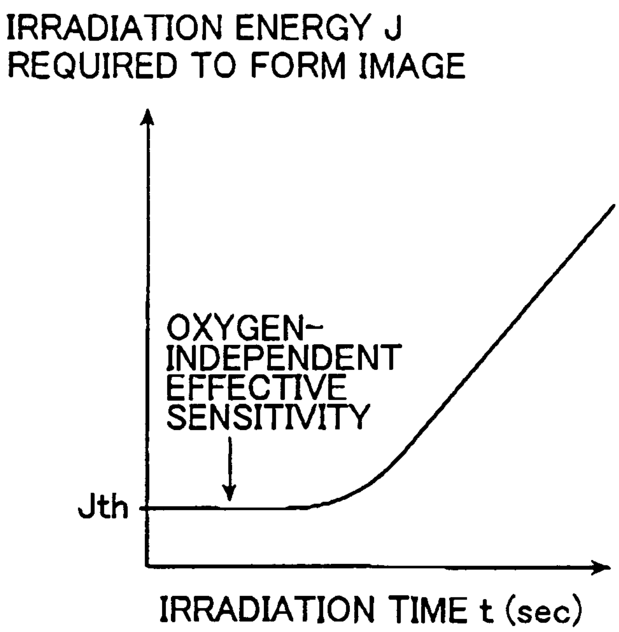
IRRADIATION ENERGY J
REQUIRED TO FORM IMAGE
OXYGEN-
INDEPENDENT
EFFECTIVE
SENSITIVITY
Jth
IRRADIATION TIME t (sec)